(19) Europäisches Patentamt
European Patent Office
Office européen des brevets

(11) EP 2 763 200 A1

(12) EUROPEAN PATENT APPLICATION
published in accordance with Art. 153(4) EPC

(43) Date of publication:
**06.08.2014 Bulletin 2014/32**

(21) Application number: **12836159.9**

(22) Date of filing: **28.09.2012**

(51) Int Cl.:
***H01L 35/24*** *(2006.01)* ***C08G 61/12*** *(2006.01)*
***C08G 73/02*** *(2006.01)*

(86) International application number:
**PCT/JP2012/075046**

(87) International publication number:
**WO 2013/047730 (04.04.2013 Gazette 2013/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.09.2011 JP 2011213449**

(71) Applicant: **FUJI-FILM Corporation**
**Minato-ku**
**Tokyo 106-8620 (JP)**

(72) Inventors:
- **NISHIO, Ryo**
  **Ashigarakami-gun**
  **Kanagawa 258-8577 (JP)**
- **AOAI, Toshiaki**
  **Ashigarakami-gun**
  **Kanagawa 258-8577 (JP)**
- **HAYASHI, Naoyuki**
  **Ashigarakami-gun**
  **Kanagawa 258-8577 (JP)**

(74) Representative: **HOFFMANN EITLE**
**Patent- und Rechtsanwälte**
**Arabellastrasse 4**
**81925 München (DE)**

# (54) THERMOELECTRIC CONVERSION MATERIAL AND THERMOELECTRIC CONVERSION ELEMENT

(57) A thermoelectric conversion material containing an electrically conductive polymer and a thermal excitation assist agent, wherein the thermal excitation assist agent is a compound that does not form a doping level in the electrically conductive polymer, an energy level of LUMO (lowest unoccupied molecular orbital) of the thermal excitation assist agent and an energy level of HOMO (highest occupied molecular orbital) of the electrically conductive polymer satisfy following numerical expression (I): Numerical expression (I);

$$0.1\text{eV} \leq |\text{HOMO of an electrically conductive polymer}| - |\text{LUMO of a thermal excitation assistant agent}| \leq 1.9\ \text{eV}$$

wherein, in numerical expression (I), |HOMO of an electrically conductive polymer| represents an absolute value of an energy level of HOMO of the electrically conductive polymer, and |LUMO of a thermal excitation assist agent| represents an absolute value of an energy level of LUMO of the thermal excitation assist agent, respectively.

EP 2 763 200 A1

Fig. 1

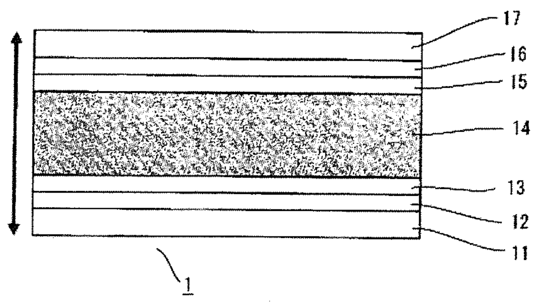


Fig. 2

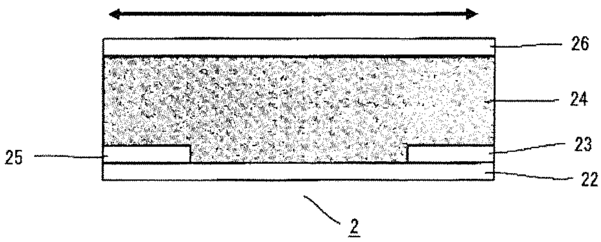


Fig. 3

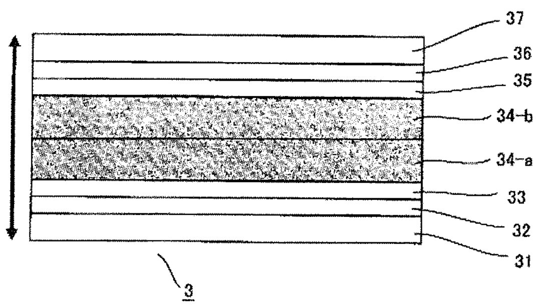


Fig. 4

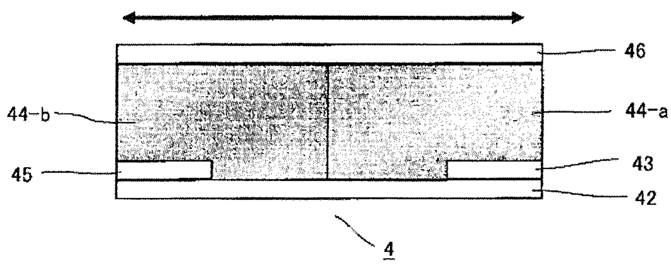

**Description**

FIELD OF THE INVENTION

The present invention relates to a thermoelectric conversion material and a thermoelectric conversion element using the material.

BACKGROUND OF THE INVENTION

A thermoelectric conversion material that allows mutual conversion between heat energy and electric energy is used for a thermoelectric conversion element such as a thermoelectric generation device and a Peltier device. In thermoelectric generation applying the thermoelectric conversion material or the thermoelectric conversion element, heat energy can be directly converted into electric power, and a movable part is not required, and thus the thermoelectric generation is used for a power supply for a wrist watch operated by body temperature, a power supply for remote districts, a space power supply or the like.

Satisfactory thermoelectric conversion efficiency is required for the thermoelectric conversion material, and one currently mainly put in practical use includes an inorganic material. However, these inorganic materials are expensive and have problems of containing a hazardous substance, or a complicated step for processing the material into the thermoelectric conversion element, or the like. Therefore, research has been advanced for an organic thermoelectric conversion material that can be relatively inexpensively produced and is also easy in processing such as film formation, and a report has been made on a thermoelectric conversion material and element using an electrically conductive polymer.

For example, Patent Literature 1 describes a thermoelectric element using an electrically conductive polymer such as polyaniline, Patent Literature 2 describes a thermoelectric conversion material containing polythienylene vinylene, and Patent Literatures 3 and 4 describe a thermoelectric material formed by doping polyaniline, respectively. Moreover, Patent Literature 5 describes an art for dissolving polyaniline into an organic solvent, spin coating of the resultant material on a substrate and forming a thin film, and a thermoelectric material using the same, but a production process therefor is complicated. Patent Literature 6 describes a thermoelectric conversion material formed of an electrically conductive polymer prepared by doping poly(3-alkylthiophene) with iodine, and reports that thermoelectric conversion characteristics of a practical use level are demonstrated. Patent Literature 7 discloses a thermoelectric conversion material formed of an electrically conductive polymer obtained by performing doping treatment of polyphenylene vinylene or alkoxy-substituted polyphenylene vinylene.

However, these thermoelectric conversion materials are still far from sufficient in thermoelectric conversion efficiency, and desire has been expressed for development of an organic thermoelectric conversion material having higher thermoelectric conversion efficiency.

CITATION LIST

Patent Literatures

Patent Literature 1: JP-A-2010-95688("JP-A" means unexamined published Japanese patent application)
Patent Literature 2: JP-A-2009-71131
Patent Literature 3: JP-A-2001-326393
Patent Literature 4: JP-A-2000-323758
Patent Literature 5: JP-A-2002-100815
Patent Literature 6: JP-A-2003-322638
Patent Literature 7: JP-A-2003-332639

SUMMARY OF THE INVENTION

PROBLEMS THAT THE INVENTION IS TO SOLVE

The present invention is contemplated for providing a thermoelectric conversion material having excellent thermopower, and a thermoelectric conversion element using the material.

MEANS TO SOLVE THE PROBLEM

In view of the above, the present inventors diligently have continued to conduct study on an improvement in thermoelectric conversion efficiency of a thermoelectric conversion material using an electrically conductive polymer. Then, the present inventors have found that a substance having a specific energy level of a molecular orbital to an energy level of a molecular orbital of the electrically conductive polymer is compounded together with the electrically conductive polymer, thereby obtaining of a thermoelectric conversion material having high thermopower, and that thermoelectric conversion performance is improved in an element using the same. The present invention has been made based on this finding.

According to the present invention, there is provided the following means:

<1> A thermoelectric conversion material containing an electrically conductive polymer and a thermal excitation assist agent, wherein the thermal excitation assist agent is a compound that does not form a doping level in the electrically conductive polymer, an energy level of LUMO (lowest unoccupied molecular orbital) of the thermal excitation assist agent and an energy level of HOMO (highest occupied molecular orbital) of the electrically conductive polymer satisfy following numerical expression (I):

Numerical expression (I);

$$0.1\text{eV} \leq |\text{HOMO of an electrically conductive polymer}| - |\text{LUMO of a thermal excitation assistant agent}| \leq 1.9\ \text{eV}$$

wherein, in numerical expression (I), |HOMO of an electrically conductive polymer| represents an absolute value of an energy level of HOMO of the electrically conductive polymer, and |LUMO of a thermal excitation assist agent| represents an absolute value of an energy level of LUMO of the thermal excitation assist agent, respectively.

<2> The thermoelectric conversion material according to the item <1>, containing a dopant and/or a carbon nanotube.

<3> The thermoelectric conversion material according to the item <1> or <2>, wherein the electrically conductive polymer is a conjugated polymer having a repeating unit derived from at least one kind of a monomer selected from the group consisting of a thiophene-based compound, a pyrrole-based compound, an aniline-based compound, an acetylene-based compound, a p-phenylene-based compound, a p-phenylenevinylene-based compound, a p-phenyleneethynylene-based compound, and derivatives thereof.

<4> The thermoelectric conversion material according to any one of the items <1> to <3>, wherein the thermal excitation assist agent is a polymer compound including at least one kind of structure selected from a benzothiadiazole skeleton, a benzothiazole skeleton, a dithienosilole skeleton, a cyclopentadithiophene skeleton, a thienothiophene skeleton, a thiophene skeleton, a fluorene skeleton and a phenylenevinylene skeleton, or a fullerene-based compound, a phthalocyanine-based compound, a perylenedicarboxyimide-based compound or a tetracyanoquinodimethane-based compound.

<5> The thermoelectric conversion material according to any one of the items <2> to <4>, wherein the dopant is an onium salt compound.

<6> The thermoelectric conversion material according to any one of the items <1> to <5>, further containing a solvent.

<7> A thermoelectric conversion element, using the thermoelectric conversion material according to any one of the items <1> to <6>.

<8> The thermoelectric conversion element according to the item <7>, having two or more thermoelectric conversion layers, wherein at least one layer of the thermoelectric conversion layers includes the thermoelectric conversion material according to any one of the items <1> to <6>.

<9> The thermoelectric conversion element according to the item <8>, wherein adjacent thermoelectric conversion layers among two or more thermoelectric conversion layers include mutually different electrically conductive polymers.

<10> The thermoelectric conversion element according to any one of the items <7> to <9>, having a substrate and a thermoelectric conversion layer arranged on the substrate.

<11> The thermoelectric conversion element according to any one of the items <7> to <10>, further having an electrode.

<12> An article for thermoelectric generation, using the thermoelectric conversion element according to any one of the items <7> to <11>.

## EFFECTS OF THE INVENTION

A thermoelectric conversion material of the present invention has excellent thermopower, and can be suitably used for a thermoelectric conversion element or various kinds of articles for thermoelectric generation. Moreover, a thermoelectric conversion element formed using the thermoelectric conversion material or an article formed using the same can develop excellent thermoelectric conversion performance.
Other and further features and advantages of the invention will appear more fully from the following description, appropriately referring to the accompanying drawings.

## BRIEF DESCRIPTION OF THE DRAWINGS

{Fig.1}
Fig. 1 is a diagram schematically showing one example of a thermoelectric conversion element of the present invention. An arrow in Fig. 1 shows a direction of temperature difference to be imparted during using the element.
{Fig. 2}
Fig. 2 is a diagram schematically showing one example of a thermoelectric conversion element of the present invention. An arrow in Fig. 2 shows a direction of temperature difference to be imparted during using the element.
{Fig. 3}
Fig. 3 is a diagram schematically showing one example of a thermoelectric conversion element of the present invention. An arrow in Fig. 3 shows a direction of temperature difference to be imparted during using the element.
{Fig. 4}
Fig. 4 is a diagram schematically showing one example of a thermoelectric conversion element of the present invention. An arrow in Fig. 4 shows a direction of temperature difference to be imparted during using the element.

## MODE FOR CARRYING OUT THE INVENTION

A thermoelectric conversion material of the present invention contains an electrically conductive polymer and a thermal excitation assist agent being a substance having a specific energy level of a molecular orbital to an energy level of a molecular orbital of the electrically conductive polymer. The thermal excitation assist agent is used together with the electrically conductive polymer, thereby allowing enhancement of thermal excitation efficiency to obtain a material having excellent thermopower.
Following, the present invention will be described in detail.

### [Electrically conductive polymer]

As the electrically conductive polymer, a polymer compound having a conjugated molecular structure can be used. Herein, the polymer having the conjugated molecular structure means a polymer having a structure in which a single bond and a double bond are alternately connected in a carbon-to-carbon bond on a main chain of the polymer.
Specific examples of these conjugated polymers include conjugated polymers having a repeating unit derived from a monomer selected form a thiophene-based compound, a pyrrole-based compound, an aniline-based compound, an acetylene-based compound, a p-phenylene-based compound, a p-phenylenevinylene-based compound, a p-phenyleneethynylene-based compound, a p-fluorenylenevinylene-based compound, a polyacene-based compound, a polyphenanthrene-based compound, a metal-phthalocyanine-based compound, a p-xylylene-based compound, a vinylenesulfide-based compound, a m-phenylene-based compound, a naphthalenevinylene-based compound, a p-phenyleneoxide-based compound, a phenylenesulfide-based compound, a furan-based compound, a selenophene-based compound, an azo-based compound, a metal complex-based compound, and a derivative formed by introducing a substituent into each of these compounds.
The substituent to be introduced into the above-described derivative is not particularly limited, but it is preferable to select the substituent in consideration of compatibility with other components, a kind of medium that can be used, or the like.
When an organic solvent is used as the medium, preferable examples of the substituent include a linear, branched, or cyclic alkyl group, alkoxy group, or thioalkyl group, and also alkoxyalkyleneoxy group, alkoxyalkyleneoxyalkyl group, crown ether group, aryl group. These groups may further have a substituent. The number of carbon atoms of the substituent is not particularly limited, but is preferably 1 to 12, and more preferably, 4 to 12. A long-chain alkyl group, alkoxy group, thioalkyl group, alkoxyalkyleneoxy group, or alkoxyalkyleneoxyalkyl group having 6 to 12 carbon atoms is particularly preferred.

When an aqueous medium is used, a hydrophilic group such as a carboxylic acid group, a sulfonate group, a hydroxyl group, and a phosphate group is preferably further introduced into each monomer terminal or the above-described substituent.

In addition thereto, a dialkylamino group, a monoalkylamino group, an amino group, a carboxyl group, an ester group, an amide group, a carbamate group, a nitro group, a cyano group, an isocyanate group, an isocyano group, a halogen atom, a perfluoroalkyl group, a perfluoroalkoxy group, or the like can be introduced as the substituent, and such introduction is preferred.

The number of substituents that can be introduced is not particularly limited, but in consideration of the dispersibility, the compatibility, the electrical conductivity, or the like of the electrically conductive polymer, one or a plurality of substituents can be introduced as appropriate.

Specific examples of the conjugated polymers having repeating units derived from the thiophene-based compounds and the derivatives thereof include polythiophene, a conjugated polymer including a repeating unit derived from a monomer having a substituent introduced into a thiophene ring, and a conjugated polymer including a repeating unit derived from a monomer having a condensed polycyclic structure including a thiophene ring.

Specific examples of the conjugated polymers including the repeating units derived from the monomers having the substituents introduced into the thiophene rings include polyalkyl-substituted thiophenes such as poly-3-methylthiophene, poly-3-butylthiophene, poly-3-hexylthiophene, poly-3-cyclohexylthiophene, paly-3-(2'-ethylhexyl)thiophene, poly-3-octylthiophene, poly-3-dodecylthiophene, poly-3-(2'-methoxyethoxy)methylthiophene, and poly-3-(methoxyethoxyethoxy)methylthiophene; poly-alkoxy-substituted thiophenes such as poly-3-methoxythiophene, poly-3-ethoxythiophene, poly-3-hexyloxythiophene, poly-3-cyclohexyloxythiophene, poly-3-(2'-ethylhexyloxy)thiophene, poly-3-dodecyloxythiophene, poly-3-methoxy(diethyleneoxy)thiophene, poly-3-methoxy(triethyleneoxy)thiophene, and poly-(3,4-ethylenedioxythiophene); poly-3-alkoxy-substituted-4-alkyl-substituted thiophenes such as poly-3-methoxy-4-methylthiophene, poly-3-hexyloxy-4-methylthiophene, and poly-3-dodecyloxy-4-methylthiophene; and poly-3-thioalkylthiophenes such as poly-3-thiohexylthiophene, poly-3-thiooctylthiophene, and poly-3-thiododecylthiophene.

Among these, poly-3-alkylthiophenes or poly-3-alkoxythiophenes are preferred. With regard to polythiophene having a substituent in 3-position, anisotropy arises depending on a bonding direction in 2- or 5-position of a thiophene ring. In polymerization of 3-substituted thiophene, a mixture is produced, including one in which the thiophene rings are bonded in 2-positions with each other (HH coupling: head-to-head), one in which the thiophene rings are bonded in 2-position and 5-position (HT coupling: head-to-tail), or one in which the thiophene rings are bonded in 5-positions with each other (TT coupling: tail-to-tail). A larger ratio of the one in which the thiophene rings are bonded in 2-position and the 5-position (HT coupling) is preferred in view of further improved planarity of a polymer main chain to further easily form a $\pi$-$\pi$ stacking structure between the polymers and to further facilitate transfer of electric charges. Ratios of these bonding patterns can be measured by H-NMR. In the polymer, a ratio of the HT coupling in which the thiophene rings are bonded in 2-position and 5-position is preferably 50% by mass or more, more preferably 70% by mass or more, and particularly preferably 90% by mass or more.

More specifically, as the conjugated polymer including the repeating unit derived from the monomer having the substituent introduced into the thiophene ring, and the conjugated polymer including the repeating unit derived from the monomer having the condensed polycyclic structure including the thiophene ring, the following compounds can be exemplified. In the following formulae, n represents an integer of 10 or more.

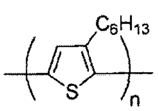

A-1

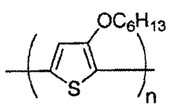

A-2

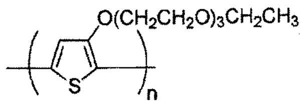

A-3

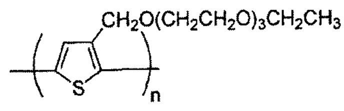

A-4

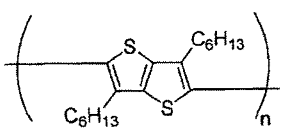

A-5

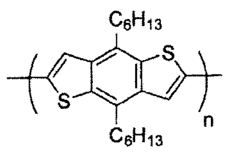

A-6

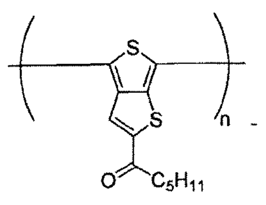

A-7

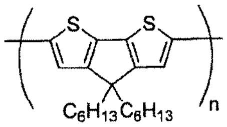

A-8

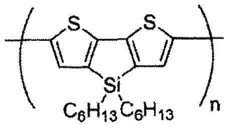

A-9

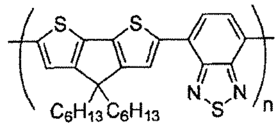

A-10

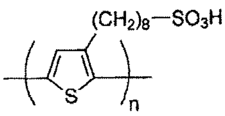

A-11

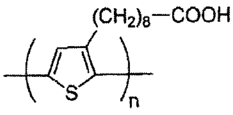

A-12

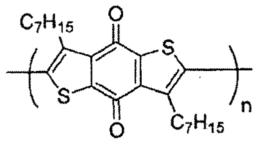

A-13

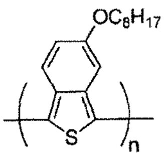

A-14

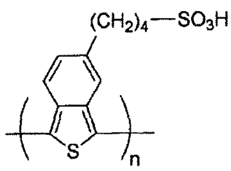

A-15

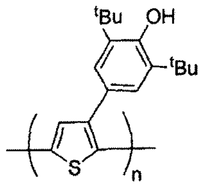

A-16

As the conjugated polymer having the repeating unit derived from the pyrrole-based compound and the derivative thereof, the following compounds can be exemplified. In the following formulae, n represents an integer of 10 or more.

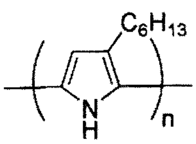

B-1

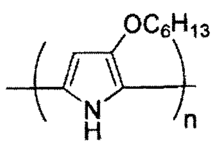

B-2

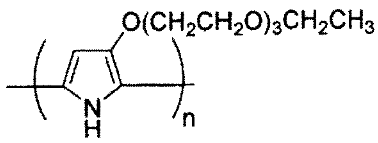

B-3

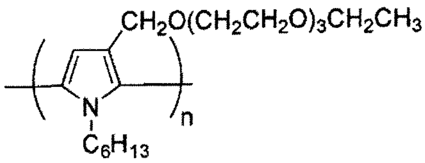

B-4

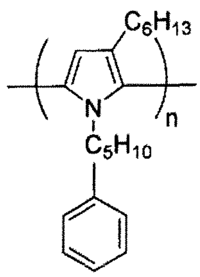

B-5

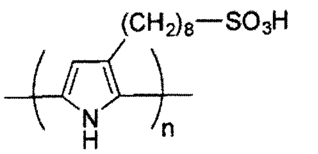

B-6

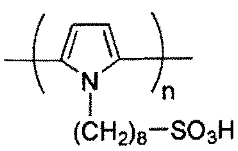

B-7

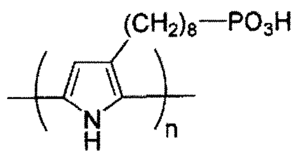

B-8

As the conjugated polymer having the repeating unit derived from the aniline-based compound and the derivative thereof, the following compounds can be exemplified. In the following formulae, n represents an integer of 10 or more.

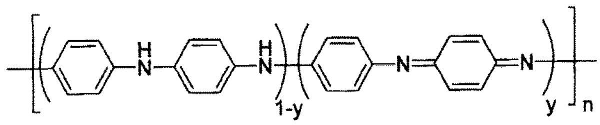

C-1

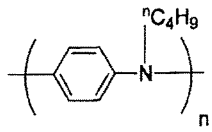

C-2

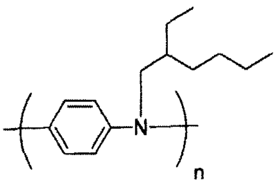

C-3

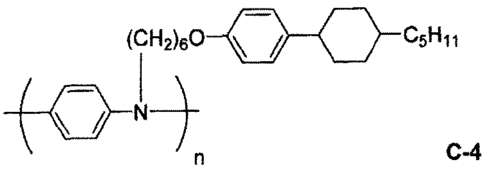

C-4

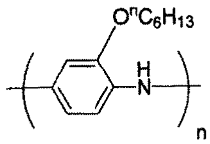

C-5

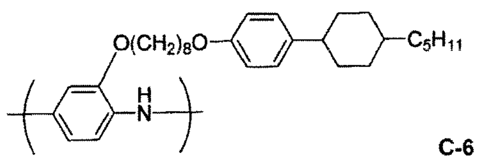

C-6

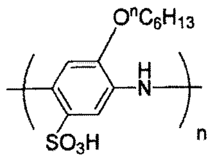

C-7

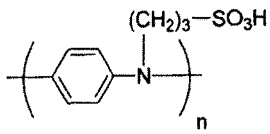

C-8

As the conjugated polymer having the repeating unit derived from the acetylene-based compound and the derivative thereof, the following compounds can be exemplified. In the following formulae, n represents an integer of 10 or more.

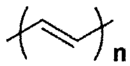

D-1

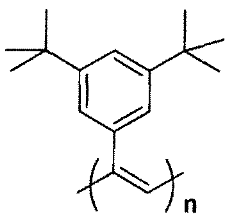

D-2

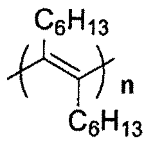

D-3

As the conjugated polymer having the repeating unit derived from the p-phenylene-based compound and the derivative thereof, the following compounds can be exemplified. In the following formulae, n represents an integer of 10 or more.

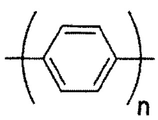

E-1

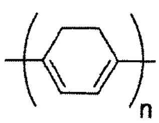

E-2

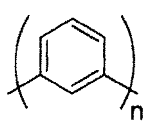

E-3

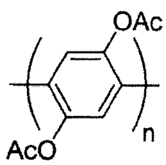

E-4

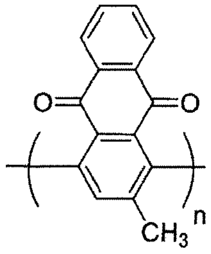

E-5

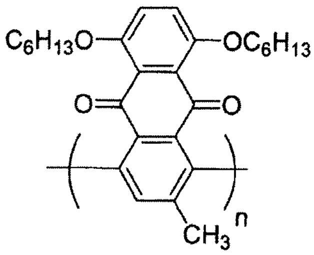

E-6

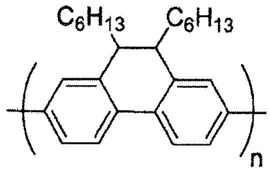

E-7

As the conjugated polymer having the repeating unit derived from the p-phenylenevinylene-based compound and the derivative thereof, the following compounds can be exemplified. In the following formulae, n represents an integer of 10 or more.

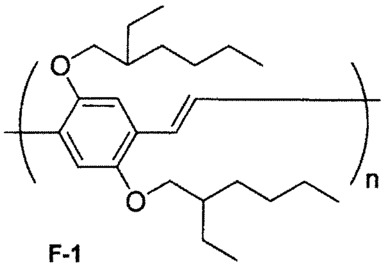

F-1

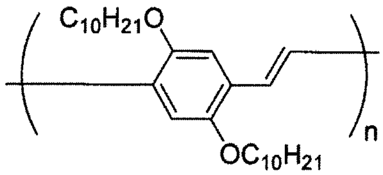

F-2

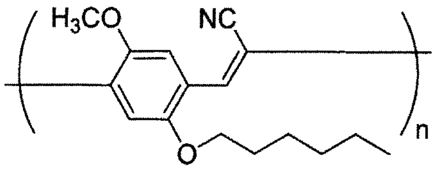

F-3

As the conjugated polymer having the repeating unit derived from the p-phenyleneethynylene-based compound and the derivative thereof, the following compounds can be exemplified. In the following formulae, n represents an integer of 10 or more.

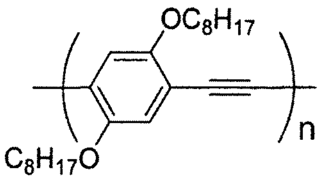

G-1

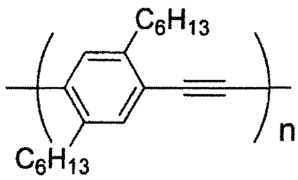

G-2

As a conjugated polymer having a repeating unit derived from a compound other than the above-described compounds and a derivative thereof, the following compounds can be exemplified. In the following formulae, n represents an integer of 10 or more.

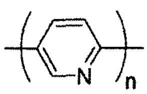

H-1

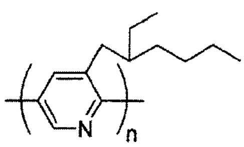

H-2

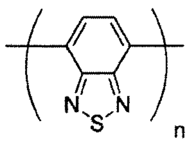

H-3

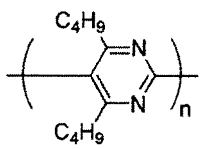

H-4

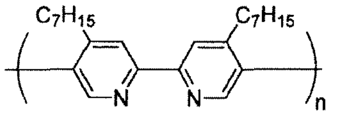 H-5 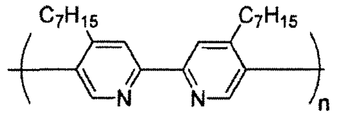 H-6

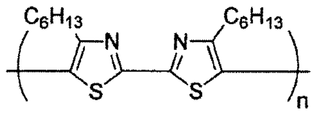 H-7 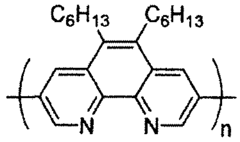 H-8

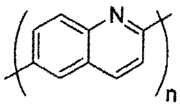 H-9 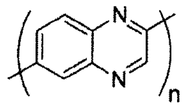 H-10 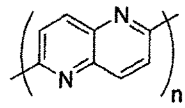 H-11

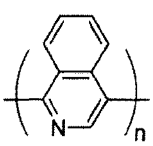 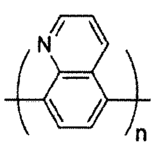 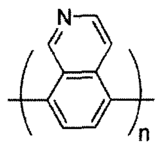 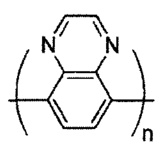

H-12 H-13 H-14 H-15

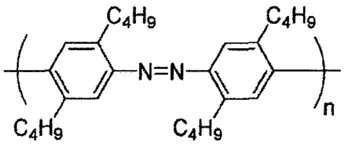 H-16 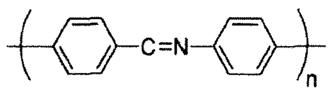 H-17

Among the above-described conjugated polymers, a linear conjugated polymer is preferably used. Such a linear conjugated polymer can be obtained, for example, in a case of the polythiophene-based polymer or the polypyrrole-based polymer, by bonding of the thiophene rings or pyrrole rings of each monomer in 2-position and 5-position, respectively. In a case of the poly-p-phenylene-based polymer, the poly-p-phenylenevinylene-based polymer, or the poly-p-phenyleneethynylene-based polymer, such a linear conjugated polymer can be obtained by bonding of the phenylene groups of each monomer in a para position (1-position and 4-position).

The electrically conductive polymer used in the present invention may have the above-mentioned repeating units (hereinafter, a monomer giving this repeating unit is also referred to as "first monomer (group of first monomers)") alone in one kind or in combination with two or more kinds. Moreover, the electrically conductive polymer may simultaneously have a repeating unit derived from a monomer having any other structure (hereinafter, also referred to as "second monomer"), in addition to the repeating unit derived from the first monomer. In a case of a polymer formed of a plurality of kinds of repeating units, the polymer may be a block copolymer, a random copolymer, or a graft polymer.

Specific examples of the second monomers having other structures used in combination with the above-described first monomer include a compound having a fluorenylene group, a carbazole group, a dibenzo[b,d]silole group, a thieno[3,2-b]thiophene group, a thieno[2,3-c]thiophene group, a benzo[1,2-b;4,5-b']dithiophene group, a cyclopenta[2,1-b;3,4-b']dithiophene group, a pyrrolo[3,4-c]pyrrole-1,4(2H,5H)-dione group, a benzo[2,1,3]thiadiazole-4,8-diyl group, an azo group, a 1,4-phenylene group, a 5H-dibenzo[b,d]silole group, a thiazole group, an imidazole group, a pyrrolo[3,4-c]pyrrole-1,4(2H,5H)-dione group, an oxadiazole group, a thiadiazole group, or a triazole group, and a derivative formed by further introducing a substituent into each of these compounds. Specific examples of the substituents to be introduced thereinto include ones similar to the above-mentioned substituents.

The electrically conductive polymer used in the present invention has the repeating units derived from one kind or a plurality of kinds of monomers selected from the group of first monomers in an amount of preferably 50% by mass or more, and more preferably 70% by mass or more, in total, in the electrically conductive polymer. The electrically conductive polymer further preferably consists of the repeating units derived from one kind or a plurality of kinds of monomers selected from the group of the first monomers. The electrically conductive polymer is particularly preferably a conjugated polymer consisting of a single repeating unit derived from a monomer selected from the group of the first monomers.

Among the groups of the first monomers, a polythiophene-based polymer including a repeating unit derived

from a thiophene-based compound and/or a derivative thereof is preferably used. A polythiophene-based polymer having the thiophene rings or a thiophene ring-including condensed aromatic ring structure as represented by the structural formulae (1) to (5) below as a repeating unit, is particularly preferred.

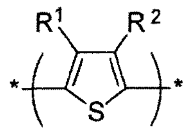
(1)

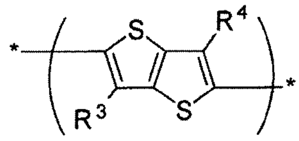
(2)

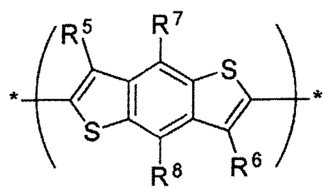
(3)

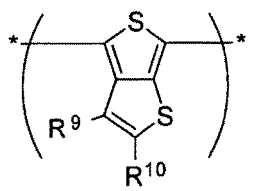
(4)

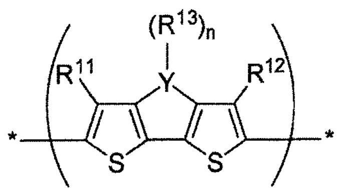
(5)

In formulae (1) to (5), $R^1$ to $R^{13}$ each independently represent a hydrogen atom, a halogen atom, an alkyl group, an alkoxy group, a perfluoroalkyl group, a perfluoroalkoxy group, an amino group, a thioether group, a polyethyleneoxy group, an ester group; Y represents a carbon atom or a nitrogen atom; n represents an integer of 1 or 2; and a symbol "*" represents a connection site of each repeating unit.
The molecular weight of the electrically conductive polymer is not particularly limited. The electrically conductive polymer may include a high-molecular-weight one, and an oligomer having molecular weight (for example, a weight average molecular weight of about 1,000 to 10,000) less than the molecular weight of the high molecular weight one.
From a viewpoint of electrical conductivity, the electrically conductive polymer is preferably hardly degradable by acid, light, or heat. In order to achieve high electrical conductivity, intramolecular carrier transfer through a long conjugated chain of the electrically conductive polymer, and intermolecular carrier hopping are required. In order to achieve the purpose, the molecular weight of the electrically conductive polymer is preferably large to some extent. From this viewpoint, the molecular weight of the electrically conductive polymer used in the present invention is preferably 5,000 or more, more preferably 7,000 to 300,000, and further preferably 8,000 to 100,000 in terms of weight average molecular weight. The weight average molecular weight can be measured by gel permeation chromatography (GPC).
These electrically conductive polymers can be produced by allowing polymerization of the above-described monomer being a constitutional unit by an ordinary oxidation polymerization process.
Moreover, commercially available products can also be used. A specific example includes regioregular poly(3-hexylthiophene-2,5-diyl) manufactured by Aldrich Corporation.
The content of the electrically conductive polymer in the thermoelectric conversion material is, in the total solid content, preferably, 30 to 90% by mass, further preferably, 35 to 80% by mass, and particularly preferably, 40 to 70%

by mass.

[Thermal excitation assist agent]

The thermal excitation assist agent used for the thermoelectric conversion material of the present invention means a compound having LUMO (Lowest Unoccupied Molecular Orbital) with a lower energy level in comparison with an energy level of LUMO of the electrically conductive polymer, and a compound that does not form a doping level in the electrically conductive polymer. As mentioned later, the thermoelectric conversion material of the present invention may contain a dopant as an arbitrary component. The dopant means a compound that forms a doping level in the electrically conductive polymer.
Whether or not the doping level is formed in the electrically conductive polymer can be evaluated by measurement of absorption spectra. In the present invention, a compound that forms the doping level or a compound that does not form the doping level refer to ones evaluated by the following method.

- Method for evaluating presence or absence of doping level formation -

Electrically conductive polymer A before doping and another component B are mixed in a weight ratio of 1:1, and absorption spectra of a thin-filmed sample is observed. As a result, when a new absorption peak different from absorption peaks of electrically conductive polymer A alone or component B alone appears, and a wavelength of the new absorption peak is on a side of wavelength longer than an absorption maximum wavelength of electrically conductive polymer A, the doping level is judged to be generated. In this case, component B is defined as a dopant.
LUMO of the thermal excitation assist agent has a lower energy level in comparison with LUMO of the electrically conductive polymer, and functions as an acceptor level of thermal excitation electrons generated from HOMO (Highest Occupied Molecular Orbital) of the electrically conductive polymer.
Further, when an absolute value of the energy level of HOMO of the electrically conductive polymer and an absolute value of the energy level of LUMO of the thermal excitation assist agent have relation satisfying the following numerical expression (I), the thermoelectric conversion material has excellent thermopower.

Numerical expression (I)

$$0.1\text{eV} \leq |\text{HOMO of the electrically conductive polymer}| - |\text{LUMO of the thermal excitation assist agent}| \leq 1.9\text{eV}$$

The above-described numerical expression (I) represents an energy difference between HOMO of the electrically conductive polymer and LUMO of the thermal excitation assist agent, and when the difference is smaller than 0.1 eV (including a case where the energy level of LUMO of the thermal excitation assist agent is lower than the energy level of HOMO of the electrically conductive polymer), activation energy of electron transfer between HOMO (donor) of the electrically conductive polymer and LUMO (acceptor) of the thermal excitation assist agent becomes very small, and therefore an oxidation-reduction reaction takes place between the electrically conductive polymer and the thermal excitation assist agent, resulting in causing aggregation. As a result, aggregation leads to deterioration of film-forming properties of a material and deterioration of electrical conductivity. Conversely, when the energy difference between both orbitals is larger than 1.9 eV, the energy difference becomes by far larger than thermal excitation energy, and therefore a thermal excitation carrier is hardly generated, more specifically, an effect of addition of the thermal excitation assist agent almost vanishes. The energy difference between both orbitals is required to be within the range of the above-described numerical expression (I) for improving the thermopower of the thermoelectric conversion material.
In addition, with regard to the energy levels of HOMO and LUMO of the electrically conductive polymer and the thermal excitation assist agent, the HOMO energy level can be measured by preparing a coating film of each single component on a glass substrate, and measuring the HOMO level according to photoelectron spectroscopy. The LUMO level can be calculated by measuring a band gap using a UV-Vis spectrophotometer, and then adding the HOMO energy as measured above. In the present invention, with regard to the energy levels of HOMO and LUMO of the electrically conductive polymer and the thermal excitation assist agent, values measured and calculated by the method are used.
In the present invention, the thermal excitation efficiency is improved by the thermal excitation assist agent, and the number of thermal excitation carriers increases, and therefore the thermopower of the material is improved. The present invention in which such a thermal excitation assist agent is used is different from the conventional technique allowing an improvement in thermoelectric conversion performance by a doping effect of the electrically conductive polymer.
In the thermoelectric conversion material, thermoelectric conversion is performed using a Seebeck effect. As

an index representing the thermoelectric conversion performance, the figure of merit ZT represented by the following numerical expression (II) is used.

$$\text{Numerical expression (II): } ZT=S^2\sigma T/\kappa$$

In numerical expression (II), S represents a Seebeck coefficient of a thermoelectric conversion material, σ represents electrical conductivity of the thermoelectric conversion material, κ represents thermal conductivity of the thermoelectric conversion material, and T represents measurement temperature.

The above-described numerical expression (II) shows that enhancement of the thermoelectric conversion performance of the thermoelectric conversion material only needs to increase the Seebeck coefficient S and the electrical conductivity σ of the material and to decrease the thermal conductivity κ. In addition, the Seebeck coefficient refers to thermopower per absolute temperature 1 K.

In the conventional technique of doping the electrically conductive polymer, the thermoelectric conversion performance is improved by enhancing the electrical conductivity of the material. In this technique, the doping level formed inside the electrically conductive polymer serves as a place in which electrons generated by thermal excitation are present. Therefore, positive holes and electrons as generated by the thermal excitation come to coexist in the vicinity of the electrically conductive polymer, the doping level of the electrically conductive polymer is easily saturated by electrons generated by thermal excitation, and progress of further thermal excitation becomes difficult, and therefore the Seebeck coefficient decreases.

On the other hand, the present invention is an art for improving the thermoelectric conversion performance by enhancing the Seebeck coefficient by using the thermal excitation assist agent. In the present invention, the electrons generated by thermal excitation exist in LUMO of the thermal excitation assist agent being the acceptor level. Therefore, the positive holes on the electrically conductive polymer and the electrons on the thermal excitation assist agent are physically separated and exist. Accordingly, the doping level of the electrically conductive polymer becomes hard to be saturated by the electrons generated by thermal excitation, and thus the Seebeck coefficient can be enhanced.

The thermal excitation assist agent preferably includes a polymer compound including at least one kind of structure selected from a benzothiadiazole skeleton, a benzothiazole skeleton, a dithienosilole skeleton, a cyclopentadithiophene skeleton, a thienothiophene skeleton, a thiophene skeleton, a fluorene skeleton and a phenylenevinylene skeleton, or a fullerene-based compound, a phthalocyanine-based compound, a perylenedicarboxyimide-based compound or a tetracyanoquinodimethane-based compound, and further preferably, a polymer compound including at least one kind of structure selected from a benzothiadiazole skeleton, a benzothiazole skeleton, a dithienosilole skeleton, a cyclopentadithiophene skeleton and a thienothiophene skeleton, or a fullerene-based compound, a phthalocyanine-based compound, a perylenedicarboxyimide-based compound or a tetracyanoquinodimethane-based compound.

Specific examples of the thermal excitation assist agents satisfying the above-mentioned features include the following ones, but the present invention is not limited thereto. In the following exemplified compounds, n represents an integer (preferably an integer of 10 or more), and Me represents a methyl group.

Thermal excitation assist agent 401

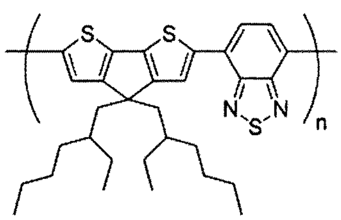

Thermal excitation assist agent 402

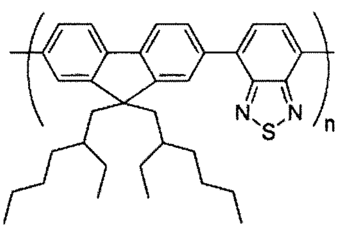

Thermal excitation assist agent 403

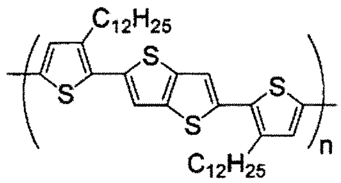

Thermal excitation assist agent 404

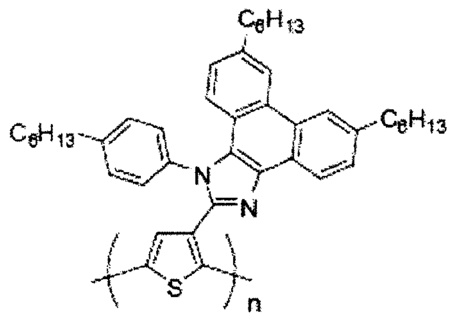

Thermal excitation assist agent 405

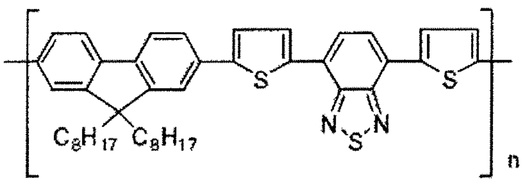

Thermal excitation assist agent 406

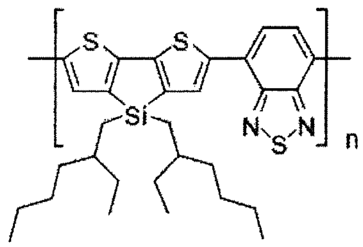

Thermal excitation assist agent 407

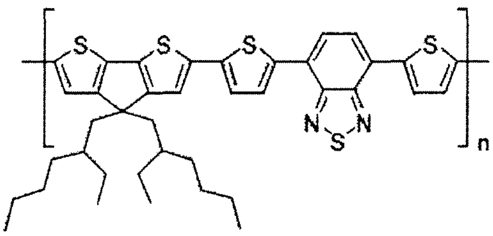

Thermal excitation assist agent 408

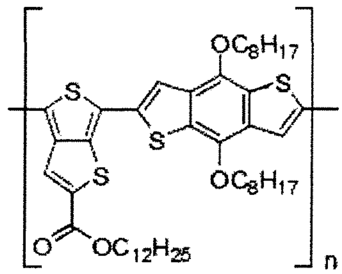

Thermal excitation assist agent 409

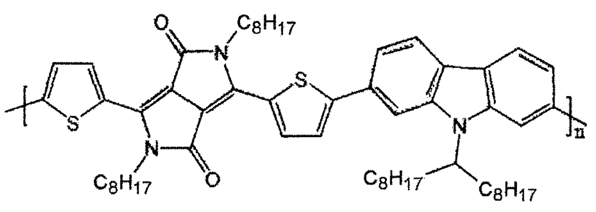

Thermal excitation assist agent 410

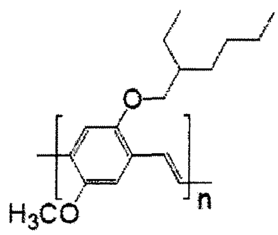

Thermal excitation assist agent 411

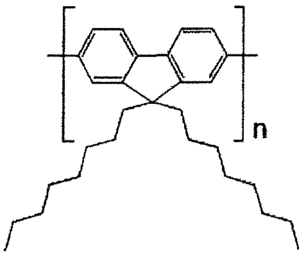

Thermal excitation assist agent 412

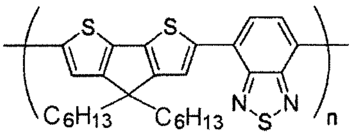

Thermal excitation assist agent 413

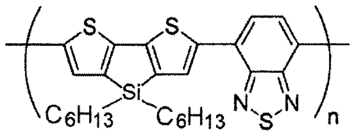

Thermal excitation assist agent 501

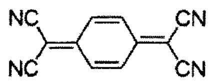

Thermal excitation assist agent 502

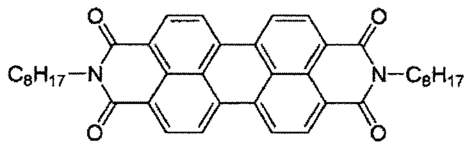

Thermal excitation assist agent 503

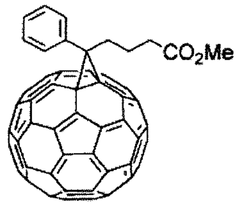

Thermal excitation assist agent 504

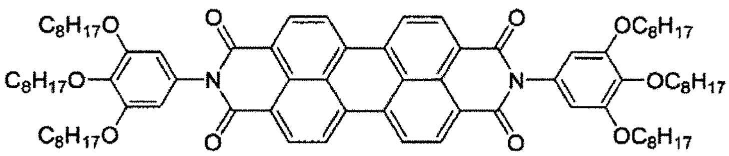

Thermal excitation assist agent 505

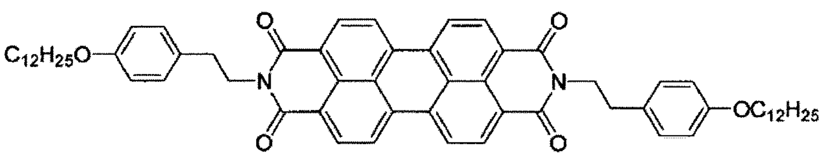

Thermal excitation assist agent 506

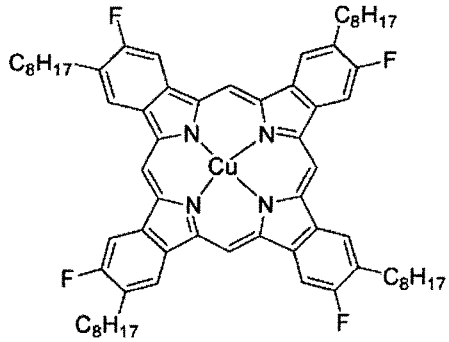

Thermal excitation assist agent 507

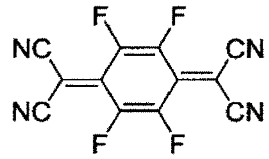

Thermal excitation assist agent 508

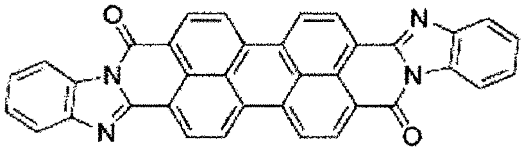

In the thermoelectric conversion material of the present invention, the above-described thermal excitation assist agent can be used alone in one kind or in combination with two or more kinds.

The content of the thermal excitation assist agent in the thermoelectric conversion material is, in the total solid content, preferably, 1 to 40% by mass, more preferably, 3 to 30% by mass, and particularly preferably, 5 to 25% by mass.

[Dopant]

The thermoelectric conversion material of the present invention preferably contains a dopant in addition to the electrically conductive polymer and the thermal excitation assist agent. As mentioned above, in the present invention, the dopant means a compound that forms the doping level in the electrically conductive polymer. The dopant forms the doping level irrespective of presence or absence of the thermal excitation assist agent.

The dopant only needs to provide the electrically conductive polymer with acid, and an onium salt compound, an oxidizing agent or an acid compound described below can be preferably used as the dopant.

1. Onium salt compound

The onium salt compound to be used as the dopant in the present invention preferably includes a compound (an acid generator, acid precursor) that generates acid by providing energy such as irradiation of active energy rays such as radiation and electromagnetic waves, or providing heat. Specific examples of such onium salt compounds include a sulfonium salt, an iodonium salt, an ammonium salt, a carbonium salt, and a phosphonium salt. Among these, a sulfonium salt, an iodonium salt, an ammonium salt, or a carbonium salt is preferred, a sulfonium salt, an iodonium salt, or a carbonium salt is more preferred. Specific examples of an anion part constituting such a salt include counter anions of strong acid.

Specific examples of the sulfonium salts include compounds represented by the following Formulae (I) and (II), specific examples of the iodonium salts include compounds represented by the following Formula (III), specific examples of the ammonium salts include compounds represented by the following Formula (IV), and specific examples of the carbonium salts include compounds represented by the following Formula (V), respectively, and such compounds are preferably used in the present invention.

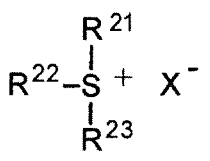

Formula (I)

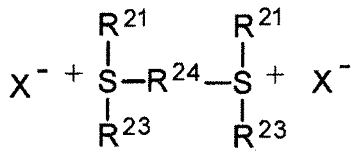

Formula (II)

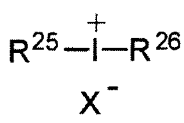

Formula (III)

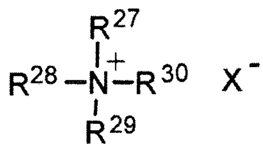

Formula (IV)

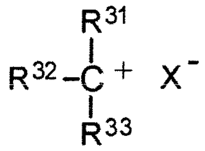

Formula (V)

In Formulae (I) to (V), $R^{21}$ to $R^{23}$, $R^{25}$ to $R^{26}$, and $R^{31}$ to $R^{33}$ each independently represent a linear, branched, or cyclic alkyl group, aralkyl group, aryl group, or aromatic heterocyclic group. $R^{27}$ to $R^{30}$ each independently represent a hydrogen atom, or a linear, branched, or cyclic alkyl group, aralkyl group, aryl group, aromatic heterocyclic group, alkoxy group, or aryloxy group. $R^{24}$ represents a linear, branched, or cyclic alkylene group or arylene group. $R^{21}$ to $R^{33}$ may be further substituted. $X^-$ represents an anion of strong acid.

Any two groups of $R^{21}$ to $R^{23}$ in Formula (I), $R^{21}$ and $R^{23}$ in Formula (II), $R^{25}$ and $R^{26}$ in Formula (III), any two groups of $R^{27}$ to $R^{30}$ in Formula (IV), and any two groups of $R^{31}$ to $R^{33}$ in Formula (V) may be bonded with each other to form an aliphatic ring, an aromatic ring, or a heterocyclic ring.

In $R^{21}$ to $R^{23}$, or $R^{25}$ to $R^{33}$, as a linear or branched alkyl group, an alkyl group having 1 to 20 carbon atoms is preferred, and specific examples include a methyl group, an ethyl group, a propyl group, a n-butyl group, a sec-butyl group, a t-butyl group, a hexyl group, an octyl group, and a dodecyl group.

As a cycloalkyl group, an alkyl group having 3 to 20 carbon atoms is preferred. Specific examples include a cyclopropyl group, a cyclopentyl group, a cyclohexyl group, a bicyclooctyl group, a norbornyl group, and an adamantyl group.

As an aralkyl group, an aralkyl group having 7 to 15 carbon atoms is preferred. Specific examples include a benzyl group, and a phenetyl group.

As an aryl group, an aryl group having 6 to 20 carbon atoms is preferred. Specific examples include a phenyl group, a naphthyl group, an anthranyl group, a phenanthryl group, and a pyrenyl group.

Specific examples of the aromatic heterocyclic groups include a pyridyl group, a pyrazol group, an imidazole group, a benzimidazole group, an indole group, a quinoline group, an isoquinoline group, a purine group, a pyrimidine group, an oxazole group, a thiazole group, and a thiazine group.

In $R^{27}$ to $R^{30}$, as an alkoxy group, a linear or branched alkoxy group having 1 to 20 carbon atoms is preferred. Specific examples include a methoxy group, an ethoxy group, an iso-propoxy group, a butoxy group, and a hexyloxy group.

As an aryloxy group, an aryloxy group having 6 to 20 carbon atoms is preferred. Specific examples include a phenoxy group and a naphthyloxy group.

In $R^{24}$, as an alkylene group, an alkylene group having 2 to 20 carbon atoms is preferred. Specific examples include an ethylene group, a propylene group, a butylene group, and a hexylene group. As a cycloalkylene group, a cycloalkylene group having 3 to 20 carbon atoms is preferred. Specific examples include a cyclopentylene group, cyclohexylene, a bicyclooctylene group, a norbornylene group, and an adamantylene group.

As an arylene group, an arylene group having 6 to 20 carbon atoms is preferred. Specific examples include a phenylene group, a naphthylene group, and an anthranylene group.

When $R^{21}$ to $R^{33}$ further have a substituent, specific examples of preferred substituents include an alkyl group having 1 to 4 carbon atoms, an alkoxy group having 1 to 4 carbon atoms, a halogen atom (a fluorine atom, a chlorine atom, or an iodine atom), an aryl group having 6 to 10 carbon atoms, an aryloxy group having 6 to 10 carbon atoms, an alkenyl group having 2 to 6 carbon atoms, a cyano group, a hydroxyl group, a carboxy group, an acyl group, an alkoxycarbonyl group, an alkylcarbonylalkyl group, an arylcarbonylalkyl group, a nitro group, an alkylsulfonyl group, a trifluoromethyl group, and -S-$R^{41}$. In addition, $R^{41}$ has the same meaning as $R^{21}$.

As $X^-$, an anion of aryl sulfonic acid, an anion of perfluoroalkyl sulfonic acid, an anion of perhalogenated Lewis acid, an anion of perfluoroalkyl sulfonimide, an anion of perhalogenated acid, or an anion of alkyl or aryl borate is preferred. These anions may further have a substituent, and a specific example of the substituent includes a fluoro group.

Specific examples of the anions of aryl sulfonic acid include p-$CH_3C_6H_4SO_3^-$, $PhSO_3^-$, an anion of naphthalene

sulfonic acid, an anion of naphthoquinone sulfonic acid, an anion of naphthalene disulfonic acid, and an anion of anthraquinone sulfonic acid.

Specific examples of the anions of perfluoroalkyl sulfonic acid include $CF_3SO_3^-$, $C_4F_9SO_3^-$, and $C_8F_{17}SO_3^-$.

Specific examples of the anions of perhalogenated Lewis acid include $PF_6^-$, $SbF_6^-$, $BF_4^-$, $AsF_6^-$, and $FeCl_4^-$.

Specific examples of the anions of perfluoroalkyl sulfonimide include $CF_3SO_2\text{-}N^-\text{-}SO_2CF_3$, and $C_4F_9SO_2\text{-}N^-\text{-}SO_2C_4F_9$.

Specific examples of the anions of perhalogenated acid include $ClO_4^-$, $BrO_4^-$, and $IO_4^-$.

Specific examples of the anions of alkyl or aryl borate include $(C_6H_5)_4B^-$, $(C_6F_5)_4B^-$, $(p\text{-}CH_3C_6H_4)_4B^-$, and $(C_6H_4F)_4B^-$.

X- includes more preferably an anion of perhalogenated Lewis acid (preferably, $PF_6^-$), an anion of perfluoroalkyl sulfonic acid, an anion of alkyl or aryl borate (preferably, $(C_6H_5)_4B^-$ or $(C_6F_5)_4B^-$, and further preferably, an anion of perhalogenated Lewis acid, an anion of perfluoroalkyl sulfonic acid, and an anion of fluoro-substituted aryl borate.

Specific examples of the onium salt compounds are shown below, but the present invention is not limited thereto.

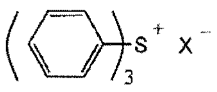

(I-1)

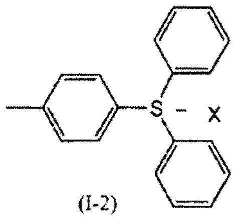

(I-2)

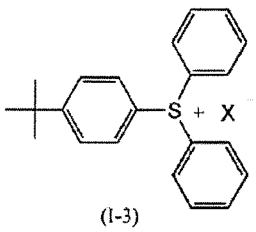

(I-3)

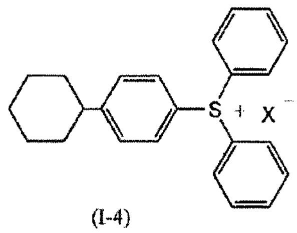

(I-4)

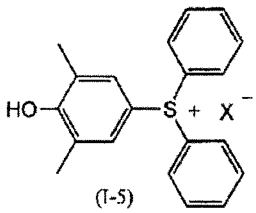

(I-5)

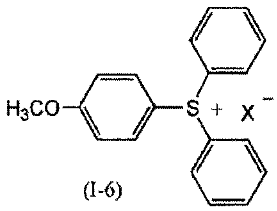

(I-6)

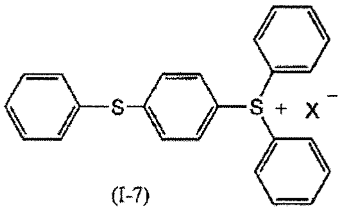

(I-7)

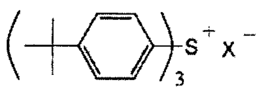

(I-8)

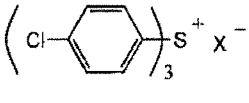

(I-9)

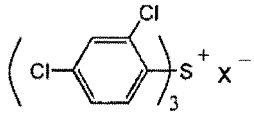

(I-10)

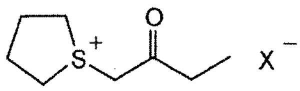

(I-11)

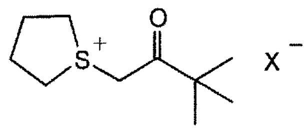

(I-12)

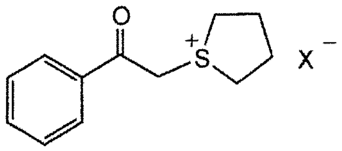

(I-13)

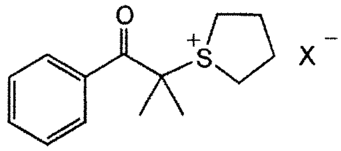

(I-14)

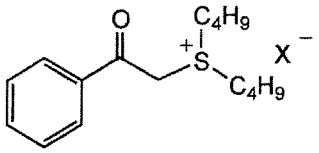

(I-15)

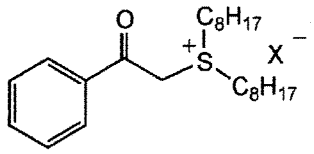

(I-16)

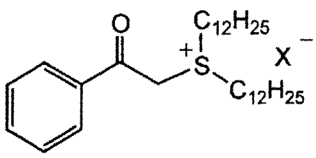

(I-17)

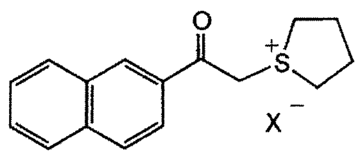

(I-18)

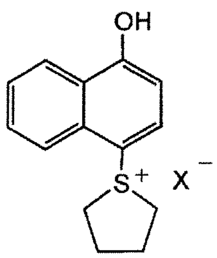

(I-19)

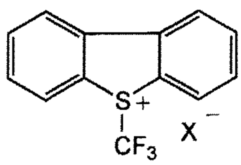

(I-20)

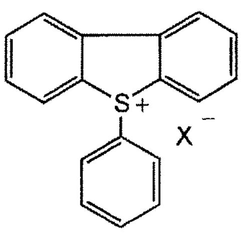

(I-21)

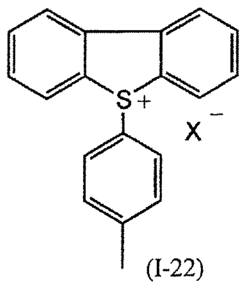

(I-22)

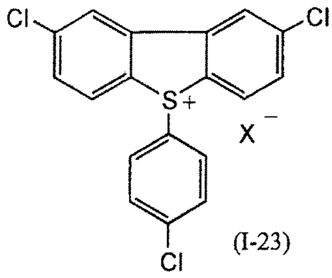

(I-23)

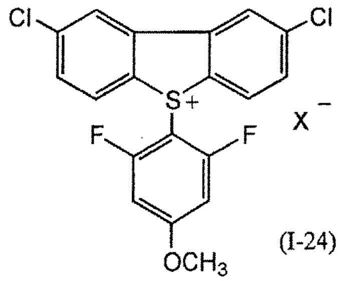

(I-24)

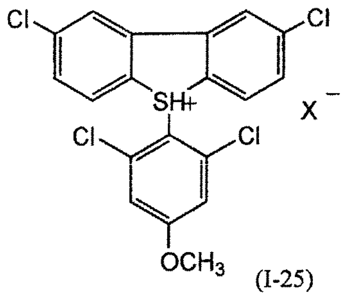

(I-25)

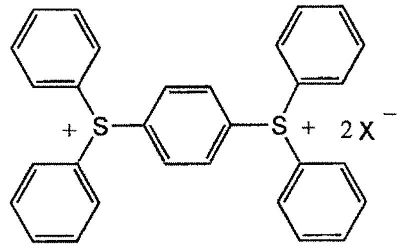

(II-1)

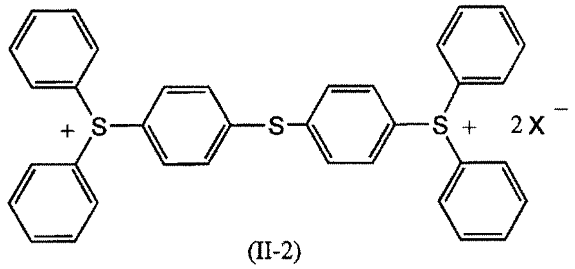

(II-2)

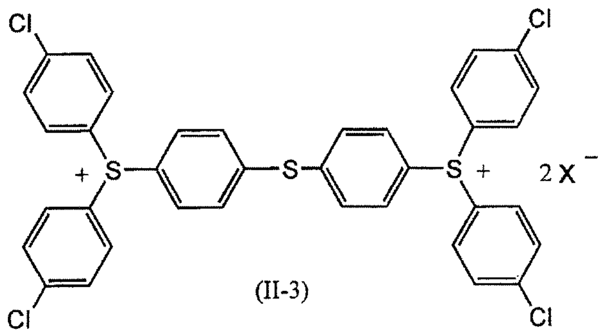

(II-3)

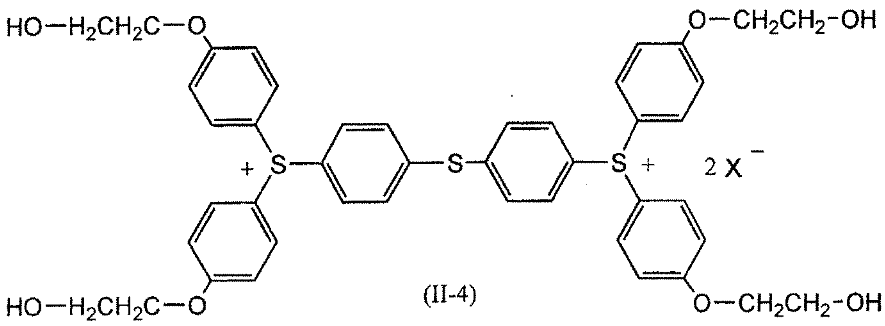

(II-4)

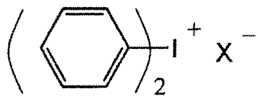

(III-1)

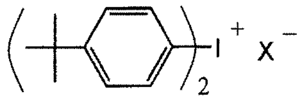

(III-2)

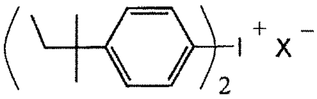

(III-3)

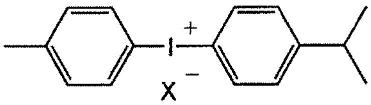

(III-4)

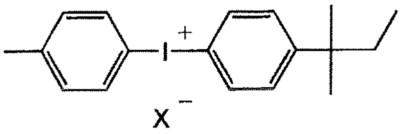

(III-5)

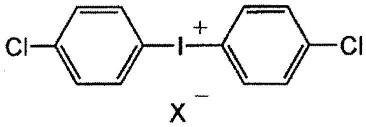

(III-6)

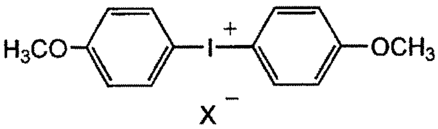

(III-7)

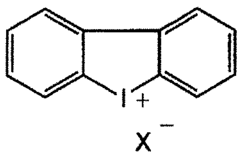

(III-8)

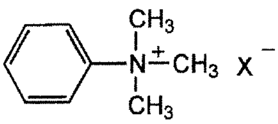

(IV-1)

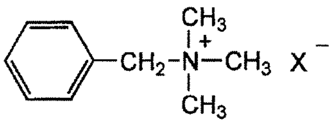

(IV-2)

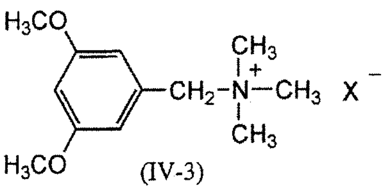

(IV-3)

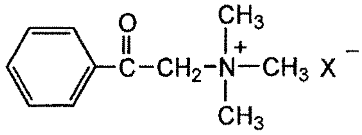

(IV-4)

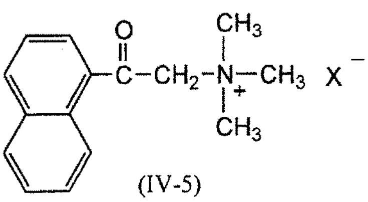

(IV-5)

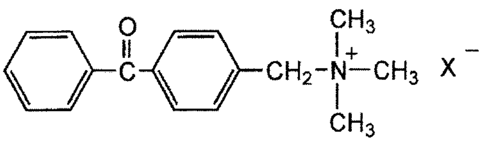

(IV-6)

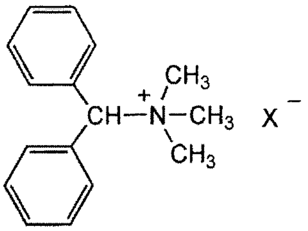

(IV-7)

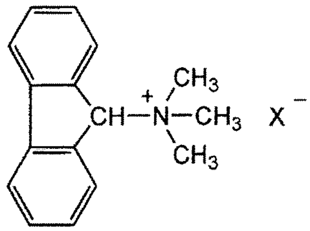

(IV-8)

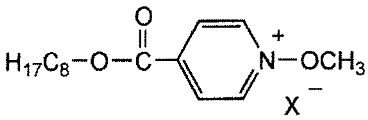

(IV-9)

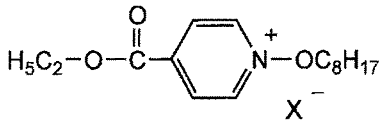

(IV-10)

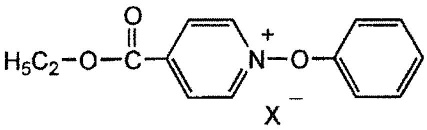

(IV-11)

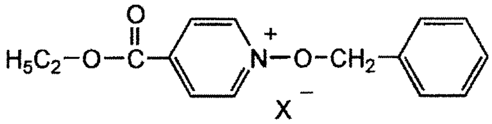

(IV-12)

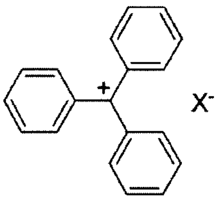

(V-1)

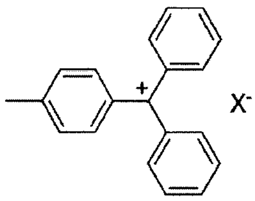

(V-2)

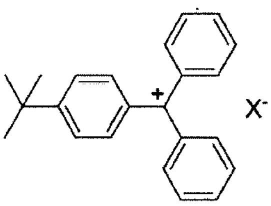

(V-3)

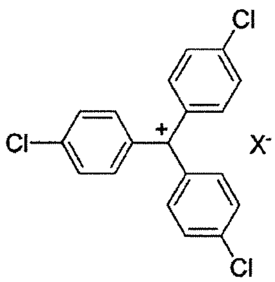

(V-4)

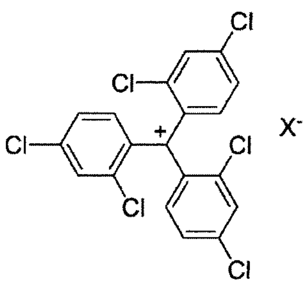

(V-5)

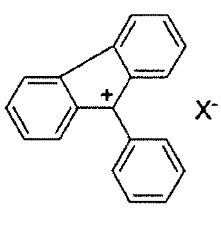

(V-6)

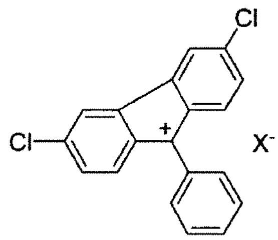

(V-7)

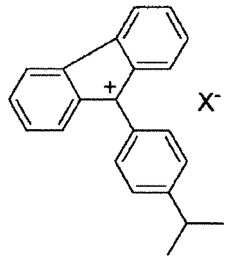

(V-8)

In the above-described specific examples, $X^-$ represents $PF_6^-$, $SbF_6^-$, $CF_3SO_3^-$, $CH_3PhSO_3^-$, $BF_4^-$, $(C_6H_5)_4B^-$, $RfSO_3^-$, $(C_6F_5)_4B^-$, or an anion represented by the following formula: and

$$CF_3SO_2-\overset{-}{N}-SO_2CF_3$$

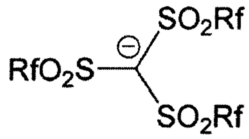

Rf represents a perfluoroalkyl group having an arbitrary substituent.

In the present invention, an onium salt compound represented by the following Formula (VI) or (VII) is particularly preferred.

Formula (VI)

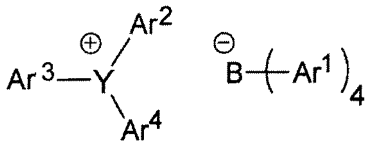

In Formula (VI), Y represents a carbon atom or a sulfur atom, $Ar^1$ represents an aryl group, and $Ar^2$ to $Ar^4$ each independently represent an aryl group or an aromatic heterocyclic group. $Ar^1$ to $Ar^4$ may further have a substituent.

$Ar^1$ preferably includes a fluoro-substituted aryl group; more preferably, a pentafluorophenyl group or a phenyl group replaced by at least one perfluoroalkyl group; and particularly preferably, a pentafluorophenyl group.

The aryl groups or the aromatic heterocyclic groups of $Ar^2$ to $Ar^4$ have the same meaning as the aryl groups or the aromatic heterocyclic groups of $R^{21}$ to $R^{23}$, or $R^{25}$ to $R^{33}$, and are preferably an aryl group, and more preferably a phenyl group. These groups may further have a substituent, and specific examples of the substituents include the above-mentioned substituents of $R^{21}$ to $R^{33}$.

Formula (VII)

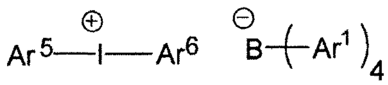

In Formula (VII), $Ar^1$ represents an aryl group, and $Ar^5$ and $Ar^6$ each independently represent an aryl group or an aromatic heterocyclic group. $Ar^1$, $Ar^5$, and $Ar^6$ may further have a substituent.

$Ar^1$ has the same meaning as $Ar^1$ in Formula (VI), and a preferred range thereof is also the same.

$Ar^5$ and $Ar^6$ each have the same meaning as $Ar^2$ to $Ar^4$ in Formula (VI), and a preferred range thereof is also the same.

The onium salt compound can be produced by an ordinary chemical synthesis. Moreover, a commercially

available reagent or the like can also be used.

One embodiment of a synthetic method of the onium salt compound is represented below, but the present invention is in no way limited thereto. Any other onium salt compound can also be synthesized by a similar technique.

Into a 500 mL volume three-necked flask, 2.68 g of triphenylsulfonium bromide (manufactured by Tokyo Chemical Industry Co., Ltd.), 5.00 g of a lithium tetrakis(pentafluorophenyl)borate-ethyl ether complex (manufactured by Tokyo Chemical Industry Co., Ltd.), and 146 mL of ethanol are put, the resultant mixture is stirred at room temperature for 2 hours, and then 200 mL of pure water is added thereto, and a precipitated white solid is fractionated by filtration. This white solid is washed with pure water and ethanol, and subjected to vacuum drying, and thus as an onium salt 6.18 g of triphenylsulfonium tetrakis(pentafluorophenyl)borate can be obtained.

2. Oxidizing agent

Specific examples of the oxidizing agent to be used as the dopant in the present invention include halogen ($Cl_2$, $Br_2$, $I_2$, ICl, $ICl_3$, IBr, IF), Lewis acid ($PF_5$, $AsF_5$, $SbF_5$, $BF_3$, $BCl_3$, $BBr_3$, $SO_3$), protonic acid (HF, HCl, $HNO_3$, $H_2SO_4$, $HClO_4$, $FSO_3H$, $ClSO_3H$, $CF_3SO_3H$, various kinds of organic acid, amino acid), a transition metal compound ($FeCl_3$, FeOCl, $TiCl_4$, $ZrCl_4$, $HfCl_4$, $NbF_5$, $NbCl_5$, $TaCl_5$, $MoF_5$, $MoCl_5$, $WF_6$, $WCl_6$, $UF_6$, $LnCl_3$ (Ln = lanthanoid such as La, Ce, Pr, Nd and Sm), an electrolytic anion ($Cl^-$, $Br^-$, $I^-$, $ClO_4^-$, $PF_6^-$, $AsF_6^-$, $SbF_6^-$, $BF_4^-$, various kinds of sulfonate anions), and also $O_2$, $XeOF_4$, $(NO_2^+)(SbF_6^-)$, $(NO_2^+)(SbCl_6^-)$, $(NO_2^+)(BF_4^-)$, $FSO_2OOSO_2F$, $AgClO_4$, $H_2IrCl_6$ and $La(NO_3)_3 \cdot 6H_2O$.

3. Acid compounds

Specific examples of the acid compounds include polyphosphoric acid, a hydroxy compound, a carboxy compound or a sulfonic acid compound.

-Polyphosphoric acid-

Polyphosphoric acid includes diphosphoric acid, pyrophosphoric acid, triphosphoric acid, tetraphosphoric acid, metaphosphoric acid and polyphosphoric acid, and a salt thereof. Polyphosphoric acid may be a mixture thereof. In the present invention, polyphosphoric acid includes preferably diphosphoric acid, pyrophosphoric acid, triphosphoric acid and polyphosphoric acid, and further preferably, polyphosphoric acid. Polyphosphoric acid can be synthesized by heating $H_3PO_4$ with a sufficient amount of $P_4O_{10}$ (phosphoric anhydride), or by heating $H_3PO_4$ to remove water.

-Hydroxy compound-

The hydroxy compound only needs to include at least one hydroxyl group, and preferably, a phenolic hydroxyl group. As the hydroxy compound, a compound represented by Formula (VIII) is preferred.

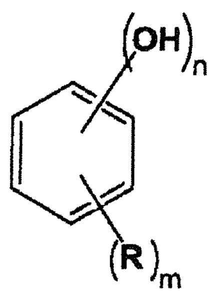

Formula (VIII)

In formula (VIII), R represents a sulfo group, a halogen atom, an alkyl group, an aryl group, a carboxy group, an alkoxycarbonyl group, n represents 1 to 6, m represents 0 to 5.

R is preferably a sulfo group, an alkyl group, an aryl group, a carboxy group, an alkoxycarbonyl group, more preferably a sulfo group.

n is preferably 1 to 5, more preferably 1 to 4, further preferably 1 to 3.

m is preferably 0 to 5, preferably 0 to 4, more preferably 0 to 3.

-Carboxy compound-

The carboxy compound only needs to include at least one carboxy group, and a compound represented by

Formula (IX) or (X) is preferred.

**HOOC-A-COOH** Formula (IX)

In Formula (IX), a symbol A represents a divalent linking group. As the divalent linking group, a combination of an alkylene group, an arylene group or an alkenylene group with an oxygen atom, a sulfur atom or a nitrogen atom is preferred, and a combination of an alkylene group or an arylene group with an oxygen atom or a sulfur atom is more preferred. In addition, when the divalent linking group is a combination of an alkylene group and a sulfur atom, the compound corresponds also to a thioether compound. Use of such a thioether compound is also preferred.

When the divalent linking group represented by A includes an alkylene group, the alkylene group may have a substituent. As the substituent, an alkyl group is preferred, and more preferably has a carboxy group as a substituent.

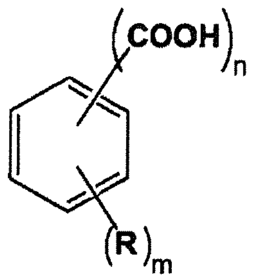

Formula (X)

In formula (X), R represents a sulfo group, a halogen atom, an alkyl group, an aryl group, a hydroxy group, an alkoxycarbonyl group, n represents 1 to 6, m represents 0 to 5.

R is preferably a sulfo group, an alkyl group, an aryl group, a hydroxy group, an alkoxycarbonyl group, more preferably a sulfo group, an alkoxycarbonyl group.

n is preferably 1 to 5, more preferably 1 to 4, further preferably 1 to 3.

m is 0 to 5, preferably 0 to 4, more preferably 0 to 3.

-Sulfonic acid compound-

A sulfonic acid compound has at least one sulfo group, and preferably has two or more sulfo groups. The sulfonic acid compound is replaced by preferably an aryl group or an alkyl group, and more preferably, an aryl group.

In the hydroxy compound and the carboxy compound as described above, a compound having a sulfo group as a substituent is also preferred.

Among the dopants, according to the present invention, the onium salt compound is preferably used, from a viewpoint of improvement in electrical conductivity, and the onium salt compound that generates acid by irradiation of active energy rays such as light, or provision of heat is preferably used. Such an onium salt compound is neutral in a state before acid release, decomposed by provision of energy such as light and heat to generate acid, and a doping effect is developed by this acid. Therefore, the thermoelectric conversion material is shaped and processed into a desired use form, and then doping can be performed by light irradiation or the like. Moreover, the onium salt compound is neutral before acid release, and therefore each component is uniformly dissolved or dispersed into the material without aggregating, precipitating the electrically conductive polymer. Therefore, coating properties or film-forming properties of the material become satisfactory, and electrical conductivity after doping is also improved.

The dopants can be used alone in one kind or in combination with two or more kinds. As for an amount of dopant used, from a viewpoint of the doping effect, the dopant is used, based on 100 parts by mass of the electrically conductive polymer, in an amount of preferably 5 parts by mass or more, more preferably, 10 to 60 parts by mass, and further preferably, 20 to 50 part by mass.

[Carbon nanotube]

The thermoelectric conversion material of the present invention preferably contains a carbon nanotube (hereinafter, abbreviated as CNT). The electrical conductivity of the material can be improved by CNT.

CNTs include a single-walled CNT in which one sheet of carbon film (graphene sheet) is cylindrically wound, a double-walled CNT in which two graphene sheets are concentrically wound, and a multi-walled CNT in which a plurality of graphene sheets are concentrically wound. In the present invention, the single-walled CNT, the double-walled CNT, and the multi-walled CNT may be used alone, or in combination with two or more kinds. A single-walled CNT and a double-walled CNT have excellent properties in the electrical conductivity and the semiconductor characteristics, and

therefore a single-walled CNT and a double-walled CNT are preferably used, and a single-walled CNT is more preferably used.

The single-walled CNT may be used in the form of a semiconductive one or a metallic one, or both in combination with the semiconductive one and the metallic one. When both of the semiconductive CNT and the metallic CNT are used, a content ratio of both in the thermoelectric conversion material can be adjusted as appropriate according to a use of the material. Moreover, the CNT may include a metal therein, or one including a molecule of fullerene or the like therein may also be used. In addition, the thermoelectric conversion material of the present invention may contain the CNT, and also nanocarbon materials such as a carbon nanohorn, a carbon nanocoil, and carbon nanobeads.

The CNT can be produced by an arc discharge process, a chemical vapor deposition process (hereinafter, referred to as a CVD process), a laser ablation process, or the like. The CNT used in the present invention may be obtained by any method, but preferably by the arc discharge process and the CVD process.

Upon producing the CNT, fullerene, graphite, or amorphous carbon is simultaneously formed as a by-product, and a catalyst metal such as nickel, iron, cobalt, and yttrium also remains. In order to remove these impurities, purification is preferably performed. A method of purification of the CNT is not particularly limited, but acid treatment by nitric acid, sulfuric acid, or the like, or ultrasonication is effective in removal of the impurities. In addition thereto, separation and removal using a filter is also preferably performed from a viewpoint of an improvement of purity.

After purification, the CNT obtained can also be directly used. Moreover, the CNT is generally produced in the form of strings, and therefore may be cut into a desired length according to a use. The CNT can be cut in the form of short fibers by acid treatment by nitric acid or sulfuric acid, ultrasonication, a freeze mill process, or the like. Moreover, in addition thereto, separation using the filter is also preferred from a viewpoint of an improvement of purity.

In the present invention, not only a cut CNT, but also a CNT previously prepared in the form of short fibers can be used. Such a CNT in the form of short fibers can be obtained, for example, by forming on a substrate a catalyst metal such as iron and cobalt, and according to the CVD method, allowing on the surface thereof vapor deposition of the CNT by thermally decomposing a carbon compound at 700 to 900°C, thereby obtaining the CNT in the shape of alignment on a substrate surface in a vertical direction. The thus prepared CNT in the form of short fibers can be taken out from the substrate by a method of stripping off the CNT, or the like. Moreover, the CNT in the form of short fibers can also be obtained by supporting a catalyst metal on a porous support such as porous silicon or on an anodized film of alumina to allow on a surface thereof vapor deposition of a CNT according to the CVD process. The CNT in the form of aligned short fibers can also be prepared according to a method in which a molecule such as iron phthalocyanine containing a catalyst metal in the molecule is used as a raw material, and a CNT is prepared on a substrate by performing CVD in a gas flow of argon / hydrogen. Furthermore, the CNT in the form of aligned short fibers can also be obtained on a SiC single crystal surface according to an epitaxial growth process

A mean length of the CNT used in the present invention is not particularly limited, but can be selected as appropriate. From viewpoints of ease of production, film-forming property, electrical conductivity, or the like, the mean length of the CNT is preferably 0.01 μm or more to 1,000 μm or less, and more preferably 0.1 μm or more to 100 μm or less.

A diameter of the CNT used in the present invention is not particularly limited, but from viewpoints of durability, transparency, film-forming property, electrical conductivity, or the like, the diameter is preferably 0.4 nm or more to 100 nm or less, more preferably 50 nm or less, and further preferably 15 nm or less.

The content of CNT in the thermoelectric conversion material is, in the total solid content, preferably, 2 to 40% by mass, more preferably, 5 to 35% by mass, and particularly preferably, 8 to 30% by mass.

[Solvent]

The thermoelectric conversion material of the present invention preferably contains a solvent.

The solvent only needs to satisfactorily disperse or dissolves each component of the material thereinto, and water, an organic solvent, and a mixed solvent thereof can be used. The solvent used is preferably an organic solvent, and preferably includes alcohol; a halogen-based solvent such as chloroform; a polar organic solvent such as DMF, NMP, and DMSO; an aromatic solvent such as chlorobenzene, dichlorobenzene, benzene, toluene, xylene, and pyridine; a ketone-based solvent such as cyclohexanone, acetone, and methyl ethyl ketone; and an ether-based solvent such as diethyl ether, THF, t-butyl methyl ether, dimethoxyethane, and diglyme.

The solvent may be used in a suitable amount according to an application of the material, and is used, based on the total solid amount of the material, in an amount of preferably 97 to 99.99% by mass, more preferably, 98 to 99.95% by mass, and further preferably, 98.5 to 99.9% by mass.

[Other component]

The thermoelectric conversion material of the present invention may appropriately contain, in addition to the above-described component, an antioxidant, a light-resistant stabilizer, a heat-resistant stabilizer and a plasticizer. The

content of the components is preferably 5% by mass or less based on the total mass of the material.

Specific examples of the antioxidant include IRGANOX 1010 (manufactured by Nihon Ciba-Geigy K.K.), SUMILIZER GA-80 (manufactured by Sumitomo Chemical Co., Ltd.), SUMILIZER GS (manufactured by Sumitomo Chemical Co., Ltd.) and SUMILIZER GM (manufactured by Sumitomo Chemical Co., Ltd.).

Specific examples of the light-resistant stabilizer include TINUVIN 234 (manufactured by BASF), CHIMASSORB 81 (manufactured by BASF) and CYASORB UV-3853 (manufactured by Sun Chemical Corporation).

Specific examples of the heat-resistant stabilizer include IRGANOX 1726 (manufactured by BASF).

Specific examples of the plasticizer include ADK CIZER RS (manufactured by ADEKA Corporation).

[Thermoelectric conversion material]

The thermoelectric conversion material of the present invention is prepared by mixing each of the above-described components. The preparation method is not particularly restricted, and preparation can be performed using an ordinary mixing apparatus or the like under ordinary temperature and normal pressure. For example, preparation may be performed by stirring, shaking or kneading each component in the solvent to dissolve or disperse the components. Ultrasonication may be performed in order to promote dissolution and dispersion.

The thermoelectric conversion element of the present invention is formed using the thermoelectric conversion material of the present invention for a thermoelectric conversion layer. A shape or a method for preparation of the thermoelectric conversion layer are not particularly limited, but is preferably formed by shaping on a substrate the thermoelectric conversion material of the present invention into a film form, and further preferably formed by coating on the substrate the thermoelectric conversion material and forming a film thereon.

As a method for coating the material and forming the film of the thermoelectric conversion layer, an ordinary coating method used for forming a polymer film can be applied, such as a spin coating method, an extrusion die coating method, a blade coating method, a bar coating method, a screen printing method, a stencil printing method, a roll coating method, a curtain coating method, a spray coating method, a dip coating method, an ink jet method, a melting extrusion molding method, a solvent casting method, and a calendering method. After coating the material, when necessary, a heating step or a drying process is arranged, and a solvent or the like may be distilled off.

For the substrate, a substrate such as glass, transparent ceramics, a metal and a plastic film can be used. Specific examples of the plastic film that can be used in the present invention include a polyester film such as a polyethylene terephthalate film, a polyethylene isophthalate film, a polyethylene naphthalate film, a polybutylene terephthalate film, a poly(1,4-cyclohexylene dimethylene terephthalate) film, a polyethylene-2,6-phthalenedicarboxylate film, and a polyester film of bisphenol A and isophthalic acid and terephthalic acid; a polycycloolefin film, in a trade name, such as Zeonor Film (manufactured by Zeon Corporation), Arton Film (manufactured by JSR Corporation) and SUMILITE FS 1700 (manufactured by SUMITOMO BAKELITE CO., LTD.); a polyimide film, in a trade name, Kapton (manufactured by DU PONT-TORAY CO., LTD.), APICAL (manufactured by Kaneka Corporation), Upilex (Ube Industries, Ltd.) and POMIRAN (manufactured by Arakawa Chemical Industries, Ltd.); a polycarbonate film, in a trade name, such as PURE ACE (manufactured by Teijin Chemicals Ltd.) and ELMEC (manufactured by Kaneka Corporation); a polyether ether ketone film, in a trade name, such as SUMILITE FS 1100 (manufactured by SUMITOMO BAKELITE CO., LTD.); and a polyphenylsulfide film, in a trade name, such as TORELINA (manufactured by Toray Industries, Inc.). Appropriate selection is allowed depending on using conditions and an environment, but from viewpoints of easy availability, heat resistance, preferably, of 100°C or higher, profitability and an effect, a commercially available polyethylene terephthalate film, polyethylene naphthalate film, various kinds of polyimide films, polycarbonate film, or the like are preferred.

In particular, use of a substrate on which various kinds of electrode materials are arranged on a compression bonding surface with the thermoelectric conversion layer. As this electrode material, such a material can be used as a transparent electrode such as ITO and ZnO, a metal electrode such as silver, copper, gold and aluminum, a carbon material such as CNT and graphene, an organic material such as PEDOT/PSS, conductive paste into which conductive particulates such as silver and carbon are dispersed, and conductive paste containing a metal nanowire of silver, copper and aluminum.

When the thermoelectric conversion material contains the onium salt compound as the dopant, heating or active energy ray irradiation is preferably performed, for a doping purpose, to the material after preparation. This treatment causes generation of acid from the onium salt compound, and when this acid protonates the electrically conductive polymer, the electrically conductive polymer is doped with a positive charge (p-type doping).

The active energy rays include radiation and electromagnetic waves, and the radiation includes particle beams (high-speed particle beams) and electromagnetic radiation. Specific examples of the particle beams include charged particle beams such as alpha rays ($\alpha$-rays), beta rays ($\beta$-rays), proton beams, electron beams (meaning ones accelerating an electron by means of an accelerator without depending on nuclear decay), and deuteron beams; non-charged particle beams such as neutron beams; and cosmic rays. Specific examples of the electromagnetic radiation include gamma rays (y-rays) and X-rays (X-rays and soft X-rays). Specific examples of the electromagnetic waves include radio waves,

infrared rays, visible rays, ultraviolet rays (near-ultraviolet rays, far-ultraviolet rays, and extreme ultraviolet rays), X-rays, and gamma rays. Types of active energy rays used in the present invention are not particularly limited. For example, electromagnetic waves having a wavelength near a maximum absorption wavelength of the onium salt compound to be used may be selected as appropriate.

Among these active energy rays, from viewpoints of the doping effect and safety, ultraviolet rays, visible rays, or infrared rays are preferred, ultraviolet rays is more preferred. Specifically, the active energy rays include rays having a maximum emission wavelength in the range of 240 to 1,100 nm, preferably in the range of 300 to 850 nm, and more preferably in the range of 350 to 670 nm.

For irradiation with active energy rays, radiation equipment or electromagnetic wave irradiation equipment is used. A wavelength of radiation or electromagnetic waves for irradiation is not particularly limited, and one allowing radiation or electromagnetic waves in a wavelength region corresponding to a response wavelength of the onium salt compound to be used may be selected.

Specific examples of the equipment allowing radiation or irradiation with electromagnetic waves include exposure equipment using as a light source an LED lamp, a mercury lamp such as a high-pressure mercury lamp, an ultra-high pressure mercury lamp, a Deep UV lamp, and a low-pressure UV lamp, a halide lamp, a xenon flash lamp, a metal halide lamp, an excimer lamp such as an ArF excimer lamp and a KrF excimer lamp, an extreme ultraviolet ray lamp, electron beams, and an X-ray lamp. Irradiation with ultraviolet rays can be applied using ordinary ultraviolet ray irradiation equipment such as commercially available ultraviolet ray irradiation equipment for curing / bonding / exposure use (for example, SP9-250UB, USHIO INC.).

Exposure time and an amount of light may be selected as appropriate in consideration of a kind of onium salt compound to be used and the doping effect. Specific examples of the amount of light include 10 $mJ/cm^2$ to 10 $J/cm^2$, and preferably 50 $mJ/cm^2$ to 5 $J/cm^2$.

With regard to doping by heating, a thermoelectric conversion material may be heated to a temperature at which the onium salt compound generates acid, or higher. A heating temperature is preferably 50°C to 200°C, and more preferably 70°C to 120°C. Heating time is preferably 5 minutes to 3 hours, and more preferably 15 minutes to 1 hour.

[Thermoelectric conversion element]

The thermoelectric conversion material of the present invention has high thermopower, and can be suitably used as a material for a thermoelectric conversion element such as a thermoelectric generation device.

The thermoelectric conversion element of the present invention is formed using the thermoelectric conversion material of the present invention, and a constitution thereof is not particularly limited. The element preferably has the substrate and the thermoelectric conversion layer including the thermoelectric conversion material of the present invention as arranged on the substrate, and more preferably, has an electrode for electrically connecting these, and further preferably, has one pair of electrodes arranged on the substrate, and the thermoelectric conversion layer between the electrodes.

In the thermoelectric conversion element of the present invention, the thermoelectric conversion layer may include one layer or two or more layers. The layer is preferably includes two or more layers.

One specific example of structure of the thermoelectric conversion element of the present invention includes structure of elements shown in Fig. 1 to Fig. 4. Element (1) in Fig. 1 and element (2) in Fig. 2 show a thermoelectric conversion element having a mono-layered thermoelectric conversion layer, and element (3) in Fig. 3 and element (4) in Fig. 4 show a thermoelectric conversion element having a multi-layered thermoelectric conversion layer, respectively. In Fig. 1 to Fig. 4, arrows show directions of temperature difference, respectively, during use of the thermoelectric conversion elements.

Element (1) shown in Fig. 1 and element (3) shown in Fig. 3 have, on first substrate (12, 32), a pair of electrodes including first electrode (13, 33) and second electrode (15, 35), and have layer (14, 34-a, 34-b) of the thermoelectric conversion material of the present invention between the electrodes. In element (3) shown in Fig. 3, a thermoelectric conversion layer includes first thermoelectric conversion layer (34-a) and second thermoelectric conversion layer (34-b), and the layers are laminated in a direction of temperature difference (in an arrow direction). Second electrode (15, 35) is arranged on second substrate (16, 36), and on an outside of first substrate (12, 32) and second substrate (16, 36), metal plate (11, 17, 31, 37) is arranged oppositely with each other.

Element (2) shown in Fig. 2 and element (4) shown in Fig. 4 have, on first substrate (22, 42), first electrode (23, 43) and second electrode (25, 45) arranged, and thereon, have thermoelectric conversion material layer (24, 44-a, 44-b) arranged. In element (4) shown in Fig. 4, a thermoelectric conversion layer includes first thermoelectric conversion layer (44-a) and second thermoelectric conversion layer (44-b), and the layers are laminated in a direction of temperature difference (an arrow direction).

In the thermoelectric conversion element of the present invention, the thermoelectric conversion material of the present invention is preferably arranged in the film form on the substrate, and this substrate is preferably functioned

as the above-described first substrate (12, 22, 32, 42). More specifically, structure is preferably formed in which various kinds of the above-mentioned electrode materials are arranged on a substrate surface (compression bonding surface with the thermoelectric conversion material), and the thermoelectric conversion material of the present invention is arranged thereon.

The thus formed thermoelectric conversion layer has one surface covered with the substrate. Upon preparing the thermoelectric conversion element by using this layer, the substrate (second substrate (16, 26, 36 or 46)) is preferably compression-bonded also on the other surface from a viewpoint of protection of the film. Moreover, various kinds of electrode materials as described above may be previously arranged on a surface (surface to be compression-bonded with the thermoelectric conversion material) of the second substrate (16 or 36). Moreover, compression bonding between the second substrate and the thermoelectric conversion material is preferably performed by heating them at about 100°C to 200°C from a viewpoint of an improvement in adhesion.

When the element of the present invention has two or more thermoelectric conversion layers, at least one layer of a plurality of thermoelectric conversion layers is formed using the thermoelectric conversion material of the present invention. More specifically, when the thermoelectric conversion element of the present invention has a plurality of the thermoelectric conversion layers, the element may have a plurality of only the thermoelectric conversion layers formed using the thermoelectric conversion material of the present invention, or the element may have the thermoelectric conversion layer formed using the thermoelectric conversion material of the present invention, and a thermoelectric conversion layer formed using a thermoelectric conversion material (hereinafter, referred to also as "second thermoelectric conversion material") other than the thermoelectric conversion material of the present invention. The element is preferably formed using the thermoelectric conversion material of the present invention in all the thermoelectric conversion layers.

For the second thermoelectric conversion material, a known thermoelectric conversion material can be used, and the material preferably contains at least the electrically conductive polymer. The electrically conductive polymer used for the second thermoelectric conversion material preferably includes one mentioned above as the electrically conductive polymer used for the thermoelectric conversion material of the present invention.

The second thermoelectric conversion material may contain a solvent and any other component in addition to the electrically conductive polymer. Specific examples of the solvent used for the second thermoelectric conversion material include a solvent used for the above-mentioned thermoelectric conversion material of the present invention, and specific examples of other components include a carbon nanotube, a dopant and a thermal excitation assist agent used for the above-mentioned thermoelectric conversion material of the present invention, respectively.

Moreover, the second thermoelectric conversion material, the content of each component, the amount of solvent used or the like can be adjusted in a manner similar to the above-mentioned thermoelectric conversion material of the present invention.

When the thermoelectric conversion element of the present invention has two or more thermoelectric conversion layers, adjacent thermoelectric conversion layers preferably include mutually different kinds of electrically conductive polymers.

For example, when both adjacent thermoelectric conversion layers 1 and 2 are formed by the thermoelectric conversion materials of the present invention, both thermoelectric conversion layers include the above-mentioned electrically conductive polymer, but the electrically conductive polymer included in thermoelectric conversion layer 1 and the electrically conductive polymer included in thermoelectric conversion layer 2 preferably have mutually different structure.

In the thermoelectric conversion element of the present invention, film thickness of the thermoelectric conversion layer (gross film thickness when the device has two or more thermoelectric conversion layers) is preferably 0.1 μm to 1,000 μm, and more preferably, 1 μm to 100 μm. Small film thickness is not preferred because temperature difference becomes hard to be imparted and resistance in the film increases.

In view of handling properties, durability or the like, thickness of each of first and second substrate is preferably 30 to 3,000 μm, more preferably, 50 to 1,000 μm, further preferably, 100 to 1,000 μm, and particularly preferably, 200 to 800 μm. A too thick substrate may occasionally cause decrease in thermal conductivity, and a too thin substrate may occasionally easily damage the film by external impact.

In general, the thermoelectric conversion element only needs one organic layer in coating and film formation of the conversion layer, and in comparison with a photoelectric conversion element such as an element for an organic thin film solar cell, the element can be further simply produced. In particular, if the thermoelectric conversion material of the present invention is used, film thickness can be further increased by 100 times to 1,000 times or the like in comparison with the element for the organic thin film solar cell, and chemical stability to oxygen or moisture in air is improved.

The thermoelectric conversion element of the present invention can be suitably used as a power generation device for an article for thermoelectric generation. Specifically, the thermoelectric conversion element can be suitably used for a generator of hot spring thermal power generation, solar thermal electric conversion or cogeneration, or a power supply for a wrist watch, a semiconductor drive power supply, a power supply for a small sized sensor, or the like.

EXAMPLES

The present invention will be described in more detail based on the following examples, but the invention is not intended to be limited thereto.

The following electrically conductive polymers and dopants were used in Examples and Comparative Examples. Moreover, thermal excitation assist agents 401 to 508 exemplified above were used for a thermal excitation assist agent.

Electrically conductive polymer 1

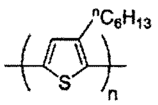

Electrically conductive polymer 2

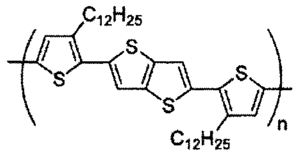

Electrically conductive polymer 3

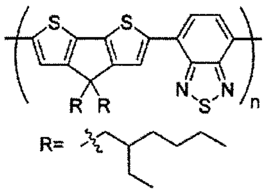

Electrically conductive polymer 4

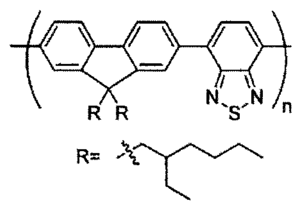

Electrically conductive polymer 5

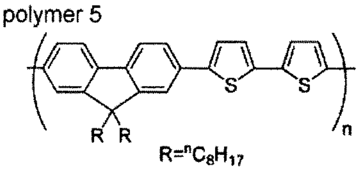

Electrically conductive polymer 6

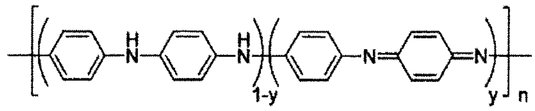

Electrically conductive polymer 7

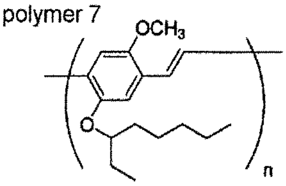

Electrically conductive polymer 8

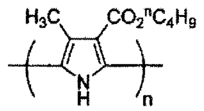

Electrically conductive polymer 9

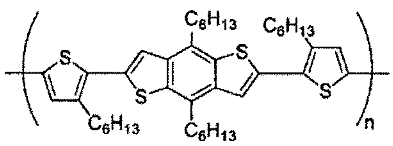

Electrically conductive polymer 10

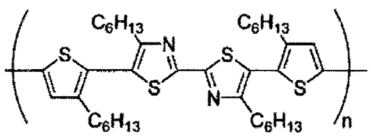

Molecular weight of each of the electrically conductive polymers 1 to 10 used is as described below.

Electrically conductive polymer 1: Weight average molecular weight =87000
Electrically conductive polymer 2: Weight average molecular weight =77000
Electrically conductive polymer 3: Weight average molecular weight =103000
Electrically conductive polymer 4: Weight average molecular weight =118000
Electrically conductive polymer 5: Weight average molecular weight =95000
Electrically conductive polymer 6: Weight average molecular weight =83000
Electrically conductive polymer 7: Weight average molecular weight =109000
Electrically conductive polymer 8: Weight average molecular weight =69000
Electrically conductive polymer 9: Weight average molecular weight =24000
Electrically conductive polymer 10: Weight average molecular weight =47000

Dopant 101

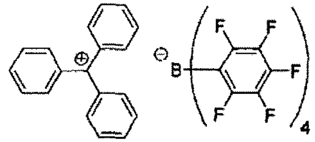

Dopant 102

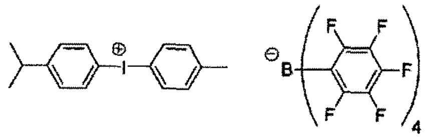

Dopant 103

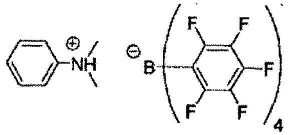

Dopant 104

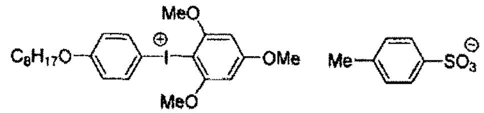

Dopant 105

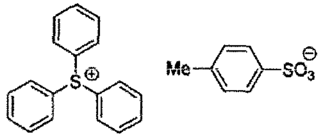

Dopant 106

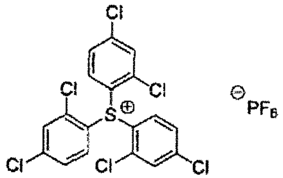

Dopant 107

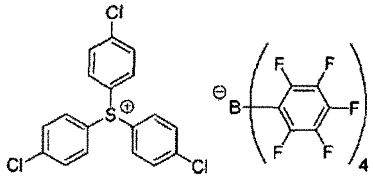

Dopant 108

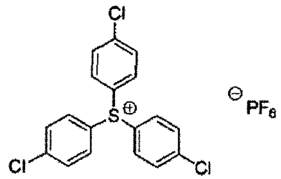

Dopant 109

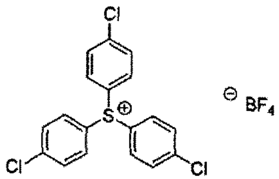

Dopant 110

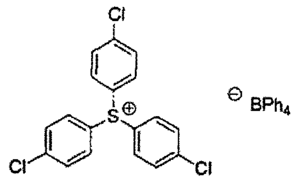

Dopant 111

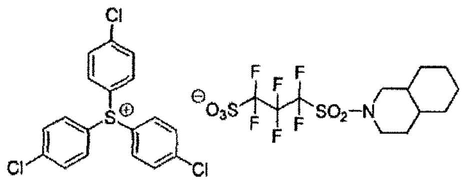

Dopant 201 $I_2$

Dopant 202 $FeCl_3$

Dopant 301 Sulfuric acid

Dopant 302 Camphorsulfonic acid

Example 1

Then, 10 mg of electrically conductive polymer 1 (weight average molecular weight = 87,000, manufactured by Sigma-Aldrich Corporation) shown below, 2 mg of the above-described thermal excitation assist agent 401, and 4 mg of CNT (ASP-100F, manufactured by Hanwha Nanotech Corporation) were added to 5 mL of orthodichlorobenzene, and dispersed thereinto for 70 minutes in an ultrasonic water bath. Then, 4 mg of dopant 107 shown below was added thereto to be sufficiently dissolved, and a mixture was prepared. This mixture was coated on a glass substrate, and a solvent was distilled off by heating the resultant coated product at 120°C for 15 minutes, and then the resultant material was dried at room temperature for 10 hours under vacuum conditions, and a 2.5 μm-thick film for thermoelectric conversion was prepared. Then, this film was irradiated with ultraviolet light (an amount of light: 1.06 J/$cm^2$) by a UV curing system (ECS-401GX, manufactured by EYE GRAPHICS Co., Ltd.), and an electrically conductive polymer was doped. Presence or absence of doping was confirmed by the following method.

With regard to the film for thermoelectric conversion obtained, thermoelectric characteristics and energy difference between HOMO of the electrically conductive polymer and LUMO of the thermal excitation assist agent were evaluated. The results are shown in Table 1.

[Confirmation of a thermal excitation assist agent not forming a doping level]

A thermal excitation assist agent used in Example was preliminarily confirmed not to form a doping level by the following measurement.

Then, 10 mg of electrically conductive polymer and 10 mg of thermal excitation assist agent were dissolved into 2 mL of chloroform (Spectrosol (trade name), manufactured by DOJINDO LABORATORIES). Spin coating of this solution was performed on a glass substrate (size: 25 mm × 25 mm), and then absorption spectra of a thin film sample dried for 1 hour under vacuum was observed.

As a result, in a case where a new absorption peak different from an absorption peak of the electrically conductive polymer alone or the thermal excitation assist agent alone appeared, and a wavelength of the new absorption peak was on a side of a wavelength longer than an absorption maximum wavelength of the electrically conductive polymer, the doping level was judged to be generated, and in a case other than the above case, the doping level was judged to be not generated.

[Confirmation of doping]

Whether or not a film for thermoelectric conversion was doped was confirmed by the following measurement.

Absorption spectra of the film were measured in a wavelength region of 300 to 2,000 nm. A new absorption peak appearing on a side of a wavelength longer than a wavelength of main absorption of an undoped film results from doping. When this absorption peak was observed, the film was judged to be doped.

[Measurement of thermoelectric characteristics (ZT value)]

With regard to the film for thermoelectric conversion as obtained, a Seebeck coefficient (unit: μV/K), at 100°C, and electrical conductivity (unit: S/cm) were evaluated using a thermoelectric characteristic measuring apparatus (RZ2001i, manufactured by OZAWA SCIENCE CO., LTD.). Then, thermal conductivity (unit: W/mK) was calculated using a thermal conductivity measuring apparatus (HC-074, manufactured by EKO Instruments Co., Ltd.). A ZT value at 100°C was calculated according to the above-described numerical expression (II) using these values, and this ZT value was taken as thermoelectric characteristics.

[Measurement of HOMO and LUMO energy levels]

A HOMO energy level and a LUMO energy level of an electrically conductive polymer and a thermal excitation assist agent were determined by the following method, respectively.

With regard to the HOMO energy level, a coating film of each single component was prepared on a glass substrate, respectively, and the HOMO energy level was measured by photoelectron spectroscopy (AC-2, manufactured by RIKEN KEIKI Co., Ltd.). With regard to the LUMO energy level, a band gap was measured using a UV-Vis spectrophotometer (UV-3600, manufactured by Shimadzu Corporation), and then the LUMO energy level was calculated by adding the measured value to the HOMO energy level as previously measured.

Subsequently, difference between an absolute value of the energy level of HOMO of the electrically conductive polymer and an absolute value of the energy level of LUMO of the thermal excitation assist agent: |HOMO of an electrically conductive polymer| - |LUMO of a thermal excitation assist agent| was determined.

Examples 2 to 29, Comparative Examples 1 to 9

Films for thermoelectric conversion in Examples 2 to 29 and Comparative Examples 1 to 9 were produced and evaluated in a manner similar to the operations in Example 1 except that electrically conductive polymers, thermal excitation assist agents, and kinds of dopants and presence or absence of addition thereof were changed as shown in Table 1 or Table 2. The results are shown in Table 1 and Table 2.

Table 1

| | Kind of Electrically conductive polymer | Kind of thermal excitation assist agent | \|HOMO of the electrically conductive polymer\|-\|LUMO of the thermal excitation assist agent\| (eV) | Additive | Thermoelectric characteristics (ZT relative value) |
|---|---|---|---|---|---|
| Ex 1 | Ecp 1 | Teaa 401 | 1.1 | CNT, Dopant 107 | 100 (reference value) |
| Ex 2 | Ecp 1 | Teaa 402 | 1.6 | CNT, Dopant 101 | 117 |
| Ex 3 | Ecp 1 | Teaa 403 | 1.5 | CNT, Dopant 103 | 104 |
| Ex 4 | Ecp 1 | Teaa 501 | 0.3 | CNT, Dopant 102 | 113 |
| Ex 5 | Ecp 1 | Teaa 502 | 1.2 | CNT, Dopant 105 | 75 |
| Ex 6 | Ecp 1 | Teaa 503 | 0.6 | CNT, Dopant 104 | 128 |
| Ex 7 | Ecp 2 | Teaa 504 | 1.4 | CNT, Dopant 107 | 102 |
| Ex 8 | Ecp 2 | Teaa 407 | 1.6 | CNT, Dopant 106 | 113 |
| Ex 9 | Ecp 3 | Teaa 505 | 1.5 | CNT, Dopant 108 | 122 |
| Ex 10 | Ecp 3 | Teaa 507 | 0.4 | CNT, Dopant 110 | 71 |
| Ex 11 | Ecp 4 | Teaa 401 | 1.7 | CNT, Dopant 109 | 88 |
| Ex 12 | Ecp 5 | Teaa 408 | 1.8 | CNT, Dopant 111 | 81 |
| Ex 13 | Ecp 5 | Teaa 406 | 1.5 | CNT, Dopant 107 | 106 |

(continued)

| | Kind of Electrically conductive polymer | Kind of thermal excitation assist agent | \|HOMO of the electrically conductive polymer\|-\|LUMO of the thermal excitation assist agent\| (eV) | Additive | Thermoelectric characteristics (ZT relative value) |
|---|---|---|---|---|---|
| Ex 14 | Ecp 6 | Teaa 405 | 1.2 | CNT, Dopant 301 | 80 |
| Ex 15 | Ecp 7 | Teaa 506 | 1.5 | CNT, Dopant 201 | 79 |
| Ex 16 | Ecp 8 | Teaa 501 | 0.8 | CNT, Dopant 202 | 83 |
| Ex 17 | Ecp 9 | Teaa 404 | 1.7 | CNT, Dopant 110 | 98 |
| Ex 18 | Ecp 10 | Teaa 508 | 0.9 | CNT, Dopant 110 | 108 |
| Ex 19 | Ecp 10 | Teaa 409 | 1.7 | CNT, Dopant 202 | 101 |
| C Ex 1 | Ecp 1 | Absence | - | CNT, Dopant 107 | 33 |
| C Ex 2 | Ecp 1 | Teaa 410 | 2.3 | CNT, Dopant 108 | 28 |
| C Ex 3 | Ecp 1 | Teaa 411 | 2.1 | CNT, Dopant 107 | 37 |
| C Ex 4 | Ecp 1 | Teaa 508 | -0.1 | CNT, Dopant 107 | Unmeasurable due to no film formation by aggregation |
| C Ex 5 | Ecp 7 | Teaa 408 | 2.2 | CNT, Dopant 302 | 26 |
| Ex means Example. C Ex means Comparative Example. Ecp means Electrically conductive polymer. Teaa means thermal excitation assist agent. | | | | | |

Table 2

| | Kind of electrically conductive polymer | Kind of thermal excitation assist agent | Kind of dopant | Presence or absence of CNT | Thermoelectric characteristics (ZT relative value) |
|---|---|---|---|---|---|
| Ex 20 | Ecp 2 | Teaa 407 | Dopant 102 | Presence | 111 |
| Ex 21 | Ecp 2 | Teaa 407 | Dopant 201 | Presence | 115 |

(continued)

| | Kind of electrically conductive polymer | Kind of thermal excitation assist agent | Kind of dopant | Presence or absence of CNT | Thermoelectric characteristics (ZT relative value) |
|---|---|---|---|---|---|
| Ex 22 | Ecp 2 | Teaa 407 | Dopant 108 | Presence | 120 |
| Ex 23 | Ecp 2 | Teaa 407 | Dopant 108 | Absence | 99 |
| Ex 24 | Ecp 2 | Teaa 407 | Absence | Presence | 102 |
| Ex 25 | Ecp 2 | Teaa 407 | Absence | Absence | 82 |
| Ex 26 | Ecp 3 | Teaa 505 | Dopant 106 | Presence | 119 |
| Ex 27 | Ecp 3 | Teaa 505 | Dopant 106 | Absence | 93 |
| Ex 28 | Ecp 3 | Teaa 505 | Absence | Presence | 100 |
| Ex 29 | Ecp 3 | Teaa 505 | Absence | Absence | 83 |
| C Ex 6 | Ecp 2 | Absence | Dopant 108 | Presence | 33 |
| C Ex 7 | Ecp 2 | Absence | Dopant 108 | Absence | 8 |
| C Ex 8 | Ecp 2 | Absence | Absence | Presence | 27 |
| C Ex 9 | Ecp 2 | Absence | Absence | Absence | 5 |
| Ex means Example. C Ex means Comparative Example. Ecp means Electrically conductive polymer. Teaa means thermal excitation assist agent. | | | | | |

Tables 1 and 2 clearly show that all had excellent thermoelectric characteristics in Examples 1 to 29 in which the energy level of LUMO of the thermal excitation assist agent and the energy level of HOMO of the electrically conductive polymer satisfy the above-described numerical expression (I). On the other hand, in comparison with Examples, the thermoelectric characteristics were significantly decreased in Comparative Examples 2 to 4 in which the above-described numerical expression (I) is not satisfied, and Comparative Examples 1 and 6 to 9 in which the thermal excitation assist agent was not used.

Example 30

On a glass substrate having an ITO electrode (thickness: 10 nm) as a first electrode, the mixture prepared in Example 1 was coated, and a solvent was distilled off by heating the resultant coated product at 95°C for 20 minutes, and then the resultant material was dried at room temperature for 4 hours under vacuum, and thus a 2.9 μm-thick first thermoelectric conversion layer was formed. Then, the layer was irradiated with ultraviolet light (amount of light: 1.06 J/cm$^2$) by a UV curing system (ECS-401GX, manufactured by EYE GRAPHICS Co., Ltd.), and an electrically conductive polymer was doped.

Subsequently, on the first thermoelectric conversion layer, the mixture prepared in Example 7 was coated in

a similar manner, and a solvent was distilled off at 95°C for 20 minutes, and then the resultant material was dried at room temperature for 4 hours under vacuum, and thus a second thermoelectric conversion layer was formed. Then, the layer was irradiated with ultraviolet light (amount of light: 1.06 J/$cm^2$) by a UV curing system (ECS-401GX, manufactured by EYE GRAPHICS Co., Ltd.), and an electrically conductive polymer was doped. As described above, a 5.5 μm-thick laminated thermoelectric conversion layer was prepared in which the first thermoelectric conversion layer and the second thermoelectric conversion layer were laminated.

On the second thermoelectric conversion layer, aluminum was installed by a vacuum deposition method as a second electrode (electrode thickness: 20 nm), and a thermoelectric conversion element was prepared.

Examples 31 to 33

A thermoelectric conversion element was prepared in a manner similar to the operations in Example 30 except that electrically conductive polymers, thermal excitation assist agents, and kinds of additives were changed as shown in Table 3.

Examples 34 to 35

Mixtures for first, second and third thermoelectric conversion layers were prepared in a manner similar to the operations in Example 30 except that electrically conductive polymers, thermal excitation assist agents, and kinds of additives were changed as shown in Table 4.

These mixtures were used, and in a manner similar to the operations in Example 30, on a first electrode, coating and film formation were sequentially made for forming a first thermoelectric conversion layer, a second thermoelectric conversion layer and a third thermoelectric conversion layer, and further a second electrode was installed, and thus a thermoelectric conversion element was prepared.

Example 36

Mixtures for first, second, third and fourth thermoelectric conversion layers were prepared in a manner similar to the operations in Example 30 except that electrically conductive polymers, thermal excitation assist agents, and kinds of additives were changed as shown in Table 4.

These mixtures were used, and in a manner similar to the operations in Example 30, on a first electrode, coating and film formation were sequentially made for forming a first thermoelectric conversion layer, a second thermoelectric conversion layer, a third thermoelectric conversion layer and a fourth thermoelectric conversion layer, and further a second electrode was installed, and thus a thermoelectric conversion element was prepared.

Example 37

In a manner similar to the operations in Example 30, mixture A for a thermoelectric conversion layer as including electrically conductive polymer 5, CNT, dopant 107 and thermal excitation assist agent 406, and mixture B including electrically conductive polymer 2, CNT, dopant 107 and thermal excitation assist agent 504 were prepared, respectively.

In a manner similar to the operations in Example 30, on a first electrode, film formation was sequentially made for forming a first thermoelectric conversion layer using mixture A, a second thermoelectric conversion layer using mixture B, a third thermoelectric conversion layer using mixture A and a fourth thermoelectric conversion layer using mixture B, and further a second electrode was installed, and thus a thermoelectric conversion element was prepared. The element obtained had a thermoelectric conversion layer taking repetition structure of first electrode - A layer-B layer - A layer - B layer - second electrode, and a gross film thickness of thermoelectric conversion layers including four layers was 9.0 μm.

Example 38

In a manner similar to the operations in Example 30, a mixture for a thermoelectric conversion layer was prepared, and then film formation was made using the same for forming a first thermoelectric conversion layer on a first electrode, and further a second electrode was installed, and thus a thermoelectric conversion element was prepared.

Example 39

In a manner similar to the operations in Example 31, a mixture including electrically conductive polymer 2, CNT, dopant 107 and thermal excitation assist agent 504, and a mixture including electrically conductive polymer 5, CNT, dopant 107 and thermal excitation assist agent 406 were separately prepared, respectively. Identical weight of each

mixture was fractionated and mixed for 10 minutes by means of ultrasonic waves.

On a glass substrate having an ITO electrode (thickness: 10 nm) as a first electrode, this mixture was coated, and a solvent was distilled off by heating the resultant coated product at 95°C for 20 minutes, and then the resultant material was dried at room temperature for 4 hours under vacuum, and thus a 6.5 μm-thick single thermoelectric conversion layer having no laminated structure was formed. Then, in a manner similar to the operations in Example 30, aluminum was installed as a second electrode (electrode thickness: 20 nm), and thus a thermoelectric conversion element was prepared.

[Measurement of thermoelectric characteristics (output)]

A thermoelectric characteristics of the thermoelectric conversion element obtained were measured by the following.

A side of the second electrode of the thermoelectric conversion element was adhered onto a hot plate (model number: HP-2LA, manufactured by AS ONE Corporation) having a set temperature of 55°C, and a cold plate (model number: 980-127DL, manufactured by Nippon Digital Corporation) having a set temperature of 25°C was adhered to a side of the first electrode. Thermopower (unit: V) and current (unit: A) as generated between the first electrode and the second electrode were multiplied, thereby calculating an output (unit: W) of the thermoelectric conversion element, and this value was taken as a value of thermoelectric characteristics.

An output of each element was expressed in terms of a relative value in which an output value of the element in Example 38 was taken as 100, and evaluated. The results are shown in Tables 3 to 5.

Table 3

| Thermoelectric conversion layer | | Example 30 | Example 31 | Example 32 | Example 33 |
|---|---|---|---|---|---|
| First layer | Electrically conductive polymer | 1 | 2 | 4 | 5 |
| | Additive | CNT, Dopant 107 | CNT, Dopant 107 | CNT, Dopant 109 | CNT, Dopant 107 |
| | Thermal excitation assist agent | 401 | 504 | 401 | 406 |
| Second layer | Electrically conductive polymer | 2 | 5 | 10 | 9 |
| | Additive | CNT, Dopant 107 | CNT, Dopant 107 | CNT, Dopant 110 | CNT, Dopant 110 |
| | Thermal excitation assist agent | 504 | 406 | 508 | Absence |
| Number of layers | | Two | Two | Two | Two |
| Film thickness of thermoelectric conversion layer as a whole | | 5.5μm | 5.3μm | 6.2μm | 5.5μm |
| Output (relative value) | | 359 | 330 | 305 | 252 |

Table 4

| Thermoelectric conversion layer | | Example 34 | Example 35 | Example 36 | Example 37 |
|---|---|---|---|---|---|
| First layer | Electrically conductive polymer | 1 | 3 | 2 | 5 |
| | Additive | CNT, Dopant 101 | CNT, Dopant 110 | CNT, Dopant 107 | CNT, Dopant 107 |
| | Thermal excitation assist agent | 402 | 507 | 504 | 406 |
| Second layer | Electrically conductive polymer | 2 | 7 | 3 | 2 |
| | Additive | CNT, Dopant 106 | CNT, Dopant 201 | CNT, Dopant 108 | CNT, Dopant 107 |
| | Thermal excitation assist agent | 407 | 506 | 505 | 504 |
| Third layer | Electrically conductive polymer | 1 | 3 | 1 | 5 |
| | Additive | CNT, Dopant 101 | CNT, Dopant 110 | CNT, Dopant 102 | CNT, Dopant 107 |
| | Thermal excitation assist agent | 402 | 507 | 501 | 406 |
| Fourth layer | Electrically conductive polymer | | | 10 | 2 |
| | Additive | | | CNT, Dopant 110 | CNT, Dopant 107 |
| | Thermal excitation assist agent | | | 508 | 504 |
| Number of layers | | Three | Three | Four | Four |
| Film thickness of thermoelectric conversion layer as a whole | | 7.8μm | 7.6μm | 9.1μm | 9.0μm |
| Output (relative value) | | 379 | 314 | 411 | 453 |

Table 5

| Thermoelectric conversion layer | | Example 38 | Example 39 |
|---|---|---|---|
| First layer | Electrically conductive polymer | 1 | 2 and 5 |
| | Additive | CNT, Dopant 107 | CNT, Dopant 107 |
| | Thermal excitation assist agent | 401 | 504,406 |
| Number of layers | | One | One |
| Film thickness of thermoelectric conversion layer as a whole | | 6.2μm | 6.5μm |
| Output (relative value) | | 100 | 85 |

Tables 3 to 5 clearly show that laminated elements having a plurality of thermoelectric conversion layers in Examples 30 to 37 showed a higher output (thermoelectric characteristics) in comparison with the elements having the mono-layered thermoelectric conversion layers in Examples 38 to 39. Further, in comparison between Examples 31 and 39, when different kinds of electrically conductive polymers are arranged to separate layers, the output (thermoelectric characteristics) was found to be improved.

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2011-213449 filed in Japan on September 28, 2011,

which is entirely herein incorporated by reference.

REFERENCE SIGNS LIST

| | |
|---|---|
| 1, 2, 3, 4 | Thermoelectric conversion element |
| 11, 17, 31, 37 | Metal plate |
| 12, 22, 32, 42 | First substrate |
| 13, 23, 33, 43 | First electrode |
| 14, 24 | Thermoelectric conversion layer |
| 34-a, 44-a | First thermoelectric conversion layer |
| 34-b, 44-b | Second thermoelectric conversion layer |
| 15, 25, 35, 45 | Second electrode |
| 16, 26, 36, 46 | Second substrate |

**Claims**

1. A thermoelectric conversion material comprising an electrically conductive polymer and a thermal excitation assist agent, wherein the thermal excitation assist agent is a compound that does not form a doping level in the electrically conductive polymer, an energy level of LUMO (lowest unoccupied molecular orbital) of the thermal excitation assist agent and an energy level of HOMO (highest occupied molecular orbital) of the electrically conductive polymer satisfy following numerical expression (I):

Numerical expression (I);

$$0.1\text{eV} \leq |\text{HOMO of an electrically conductive polymer}| - |\text{LUMO of a thermal excitation assistant agent}| \leq 1.9\text{ eV}$$

wherein, in numerical expression (I), |HOMO of an electrically conductive polymer| represents an absolute value of an energy level of HOMO of the electrically conductive polymer, and |LUMO of a thermal excitation assist agent| represents an absolute value of an energy level of LUMO of the thermal excitation assist agent, respectively.

2. The thermoelectric conversion material according to Claim 1, comprising a dopant and/or a carbon nanotube.

3. The thermoelectric conversion material according to Claim 1 or 2, wherein the electrically conductive polymer is a conjugated polymer having a repeating unit derived from at least one kind of a monomer selected from the group consisting of a thiophene-based compound, a pyrrole-based compound, an aniline-based compound, an acetylene-based compound, a p-phenylene-based compound, a p-phenylenevinylene-based compound, a p-phenyleneethynylene-based compound, and derivatives thereof.

4. The thermoelectric conversion material according to any one of Claims 1 to 3, wherein the thermal excitation assist agent is a polymer compound including at least one kind of structure selected from a benzothiadiazole skeleton, a benzothiazole skeleton, a dithienosilole skeleton, a cyclopentadithiophene skeleton, a thienothiophene skeleton, a thiophene skeleton, a fluorene skeleton and a phenylenevinylene skeleton, or a fullerene-based compound, a phthalocyanine-based compound, a perylenedicarboxyimide-based compound or a tetracyanoquinodimethane-based compound.

5. The thermoelectric conversion material according to any one of Claims 2 to 4, wherein the dopant is an onium salt compound.

6. The thermoelectric conversion material according to any one of Claims 1 to 5, further comprising a solvent.

7. A thermoelectric conversion element, using the thermoelectric conversion material according to any one of Claims 1 to 6.

**8.** The thermoelectric conversion element according to Claim 7, comprising two or more thermoelectric conversion layers, wherein at least one layer of the thermoelectric conversion layers includes the thermoelectric conversion material according to any one of Claims 1 to 6.

**9.** The thermoelectric conversion element according to Claim 8, wherein adjacent thermoelectric conversion layers among two or more thermoelectric conversion layers comprise mutually different electrically conductive polymers.

**10.** The thermoelectric conversion element according to any one of Claims 7 to 9, comprising a substrate and a thermoelectric conversion layer arranged on the substrate.

**11.** The thermoelectric conversion element according to any one of Claims 7 to 10, further comprising an electrode.

**12.** An article for thermoelectric generation, using the thermoelectric conversion element according to any one of Claims 7 to 11.

*Fig. 1*

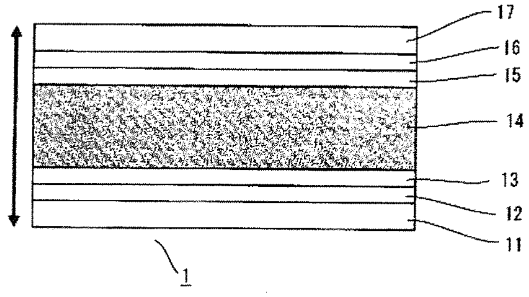


*Fig. 2*

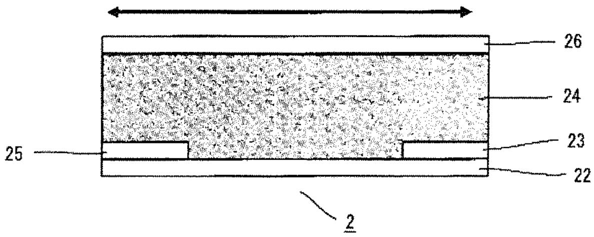


*Fig. 3*

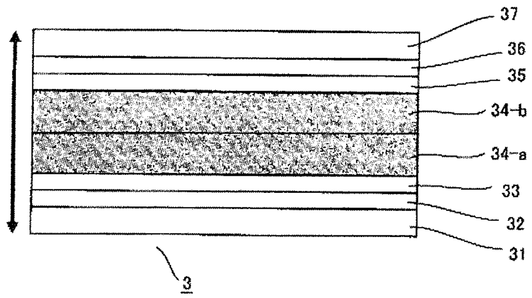


*Fig. 4*

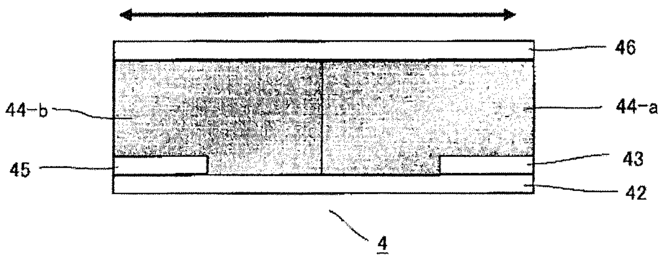

**INTERNATIONAL SEARCH REPORT**

International application No. PCT/JP2012/075046

A. CLASSIFICATION OF SUBJECT MATTER
*H01L35/24*(2006.01)i, *C08G61/12*(2006.01)i, *C08G73/02*(2006.01)i

According to International Patent Classification (IPC) or to both national classification and IPC

B. FIELDS SEARCHED

Minimum documentation searched (classification system followed by classification symbols)
H01L35/24, C08G61/12, C08G73/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
Scopus

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2002-502128 A (Uniax Corp.), 22 January 2002 (22.01.2002), paragraphs [0014], [0039] to [0041], [0046], [0051] to [0052], [0059], [0101] to [0102]; fig. 1 & US 6441395 B1 & EP 1051762 A & WO 1999/039394 A1 & CN 1295722 A | 1,3,4,6-12<br>2<br>5 |
| Y<br>A | JP 2003-332638 A (Dainippon Printing Co., Ltd.), 21 November 2003 (21.11.2003), paragraphs [0006] to [0031] (Family: none) | 2<br>5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>12 December, 2012 (12.12.12) | Date of mailing of the international search report<br>25 December, 2012 (25.12.12) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2012/075046

C (Continuation). DOCUMENTS CONSIDERED TO BE RELEVANT

| Category* | Citation of document, with indication, where appropriate, of the relevant passages | Relevant to claim No. |
|---|---|---|
| A | WO 2011/100438 A2 (ARIZONA BOARD OF REGENTS ON BEHALF OF THE UNIVERSITY OF ARIZONA), 18 August 2011 (18.08.2011), entire text; all drawings (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010095688 A
- JP 2009071131 A
- JP 2001326393 A
- JP 2000323758 A
- JP 2002100815 A
- JP 2003322638 A
- JP 2003332639 A
- JP 2011213449 A